# EUROPEAN PATENT SPECIFICATION

(11) **EP 4 285 132 B1**
(45) Date of publication and mention of the grant of the patent: **27.08.2025**
(21) Application number: 22702194.6
(22) Date of filing: 20.01.2022
(51) Int. Cl.: G01R 33/48

(54) **MONITORING OF FMRI EXAMINATION**
ÜBERWACHUNG EINER FMRI-UNTERSUCHUNG
SURVEILLANCE D'EXAMEN D'IRMF

(30) Priority: 26.01.2021 EP 21153469
(43) Date of publication of application: 06.12.2023
(73) Proprietor: Koninklijke Philips N.V., 5656 AG Eindhoven (NL)
(72) Inventor: MATTERS, Marco, 5656 AG Eindhoven (NL); HUIJBERS, Willem, 5656 AG Eindhoven (NL); LAMERICHS, Rudolf Mathias Johannes Nicolaas, 5656 AG Eindhoven (NL); VAN EE, Raymond, 5656 AG Eindhoven (NL); LEUFKENS, Timmy Robertus Maria, 5656AG Eindhoven (NL); WESTERINK, Joanne Henriëtte Desirée Monique, 5656AG Eindhoven (NL); MENA BENITO, Maria Estrella, 5656AG Eindhoven (NL)
(74) Representative: Philips Intellectual Property & Standards
(86) International application number: PCT/EP2022/051181
(87) International publication number: WO 2022/161838

(56) References cited:
- WO-A2-2010/053976
- US-A1- 2014 206 982
- US-A1- 2019 159 715
- R THEODOR STEGER ET AL: "Real-time motion detection of functional MRI data", JOURNAL OF APPLIED CLINICAL MEDICAL PHYSICS, vol. 5, no. 2, 1 January 2004 (2004-01-01), pages 64 - 70, XP055078823

## Description

### FIELD OF THE INVENTION

The present invention relates to the field of functional magnetic resonance imaging, and, more specifically, the invention relates to a device and method for monitoring the performance of a predetermined task by a subject, e.g. the subject's compliance with the intended task, during a functional imaging procedure.

### BACKGROUND OF THE INVENTION

Magnetic resonance imaging (MRI) is an extraordinary tool for non-invasively imaging internal body structures in the human or animal body. A strong magnetic field is used in MRI to align the nuclear spins of atoms in the body, after which return signals emitted due to the relaxation of these spins can be studied in a location dependent manner, e.g. using suitable magnetic field gradients and purposefully designed radiofrequency excitation pulses. Many techniques exist in the art to prepare and/or process the observed signals, such as to create images that are sensitive to various material properties in the body.

One type of these techniques relates to creating a detectable image contrast indicative of blood oxygenation. This allows the detection of a hemodynamic response in active areas in the brain, and thus to determine which areas in the brain are active. These MRI techniques, e.g. relying on the blood oxygen level dependent (BOLD) effect, cerebral blood flow, or similar approaches, are commonly referred to as functional magnetic resonance imaging (fMRI).

However, one of the challenges in fMRI relates to a poor image contrast generated by this BOLD effect (or alternative thereof). Namely, signal components that are not related to, e.g., the BOLD effect are typically far more pronounced (stronger by orders of magnitude) that the actual signal component of interest. This is typically overcome by applying a suitable statistical analysis (or alternative data modelling and/or mining approach) of an extended timeseries of MRI data. While collecting this timeseries, a function of the brain is (typically repeatedly) triggered to discern a change in the brain images with respect to other images that are collected in the absence of this functional trigger. A conventional approach therefore entails an analysis is which a statistical significant deviation between the active and control conditions is detected.

Functional magnetic resonance imaging (fMRI) is a versatile approach to investigate the functioning of the human brain, e.g. for research purposes, as well as for diagnosing neurological, psychiatric or other diseases and disorders involving the brain. Specific sensory, cognitive, emotional, behavioral, motivational, memory and motor functions of the brain can be visualized and studied in detail using fMRI. Thus, the involvement in specific actions of the brain (but not necessarily limited to direct and/or active tasks) of specific regions in the neocortex and the limbic system can be studied in detail.

To visualize these brain functions using fMRI, a contrast difference needs to be induced between images that are acquired while a specific function of the brain is active, e.g. by having the imaged subject perform a specific task, and reference images that are acquired in the absence of this specific function. It will be clear that the reference can relate to a condition in which the brain activity of interest is less active, instead of literally absent, or in which the reference images are acquired under a more specific control condition, e.g. a similar task is being performed that differs from the task of interest in a possibly very specific way. Many more complex or slightly different approaches can be considered, e.g. (to list only a few known variations) in which more than two conditions are contrasted against each other, instead of a single task of interest directly to a control condition, or in which a task parameter is taken into account, e.g. a variable intensity or magnitude associated with each iteration of the performed task. The task, or specific function, that is studied can also be selected from a very wide range of possibilities, e.g. including a 'task' that involves only the mere observation of a sensory stimulus, a controlled movement of muscle(s), or even the mere intention to move, a specific mental computation or thought process, an emotional cue (overt or subconscious) and/or many other possibilities.

Functional MRI can be applied for many and diverse purposes, including neuroscience research and clinical applications, such as planning of neurosurgery. One of the first practical applications of fMRI was the mapping of the primary motor cortex, which was to be avoided in surgery to avoid paralysis or deterioration of motor function, by a task consisting of a finger tapping movement in the active condition blocks (and rest as control condition).

However, most of the fMRI studies, and particularly for clinical applications, use a simple trial design, e.g. a blocked trial design in which periods (blocks) of task and control conditions alternate. Each block may consist of multiple trials or at least an extended time of assumed (task-induced) activity of the target brain area(s), such that a large signal contrast (relative to the control condition) can be build up and sustained over a plurality of image acquisitions in the block. Thus, the signal to noise ratio of the contrast of interest can be improved, and the effect of transient effects near the start (and/or end) of the trial condition can be reduced, e.g. the dependence on an accurate estimate of the activation flow coupling (AFC) response is reduced. Likewise, multiple successive iterations of the task and control block may be included in the trial paradigm to further improve robustness and sensitivity.

Regardless of the specific task paradigm and fMRI imaging protocol, the cooperation of the imaged subject in diligently performing the prescribed task is typically required. Even if a specific task were to rely only on a subconscious or autonomous reaction of the brain, the imaged subject would likely still need to cooperate in order to avoid movement artefacts that could prevent the subtle image contrast of interest from being detected. Non-compliance with the prescribed task can manifest in various ways, for example, random responses or even no responses of the test subject to the task-related cues. This could easily be caused by the subject being distracted, or even falling asleep.

It will be clearly understood that issues due to non-compliance with the prescribed task can be even more problematic, more pronounced and/or more frequently occurring in fMRI examinations of psychiatric patients and/or patients afflicted by a severe neurological disorder or trauma, e.g. epilepsy, stroke, meningioma, neuroglioma, etc.. Other factors, which may be correlated with such diseases or conditions, may include a reduced ability to perform a task due to age or disabilities.

Even considering that consenting patients may be generally highly motivated to comply with a test procedure, patients afflicted by psychiatric or neurological adverse conditions may have a reduced ability to comprehend a wide range of possible tasks instructions, a reduced attention span while performing a task, and/or physical difficulties in receiving sensory cues, in concentrating and/or in accurately and/or timely responding to a cue, amongst other possible confounding issues. Moreover, in subjects that are highly motivated to comply with a test procedure, this compliance may affect the ability to perform as desired, which may lead to false-negative fMRI results such that it may be difficult to a significance or confidence to the interpretation.

Some approaches are known in the art to alleviate the problems associated with reduced patient (or test subject) compliance. For example, an fMRI mapping approach, as known in the art, may rely on spontaneous brain activity while a subject is at rest, which is often referred to as resting state functional connectivity fMRI. Patterns of correlation between fluctuating activity in different brain regions can thus be used to assess functional connectivity and activity in the resting state, i.e. without requiring participation of the subject, e.g. even when the subject is sedated or asleep. Nonetheless, the limitations are quite clear. It is difficult to identify a specific brain region associated with a specific function, which may be important for many clinical (or research) purposes.

US 2015/272469 describes an approach to decompose fMRI data acquired from a subject while performing a functional task into task-related signals and non-task signals using a model related to the functional task. This allows the benefits of conventional event task-related fMRI (e.g. in terms of specificity to a function of interest) to be combined with the benefits of resting state functional connectivity fMRI (rs-fcfMRI), by generating a task activity map from the task signals and a non-task activity map from the non-task signals. Both maps can then be combined by a suitable weighting. This has the advantage that, if compliance is insufficient to acquire useful task-related results, one can still rely on the spontaneous activation mapping. Nonetheless, this does not solve the problem of the loss of task-related information in case of poor compliance, even though at least some information can still be gleaned from the data set.

US2019/159715A1 discloses a system in which brain activity in response to specific stimuli is determined. Follow-up tasks may be adapted to account for the actually measured brain activity. In other words, the original brain activity measurement is basically a calibration to determine the optimal task settings.

WO2010/053976A2 discloses administrating neural agents to a patient to improve the efficacy of a neurofeedback training. fMRI of the patient is taken while performing tasks under the influence of the agent and the patient is shown results of the brain activity as neurofeedback.

US2014/206982 discloses adjusting positron emision tomography (PET) results based on an fMRI scan obtained after introducing a PET tracer to a subject to measure the subject's brain activitation.

T.R. Steger and E.F. Jackson disclose, in 'Real-time motion detection of functional MRI data', J. Appl. Clin. Med. Phys, vol. 5, no. 2, p. 64-70 (2004), a method to quantify motion in real-time during a pre-surgical fMRI procedure.

### SUMMARY OF THE INVENTION

The invention concerns a method for monitoring the performance of a predetermined test task executed by a subject during a functional magnetic resonance imaging examination as defined in claim 1, a computer program product as defined in claim 13 and an fMRI system as defined in claim 14

It is an object of embodiments of the present invention to provide in good and efficient methods and means to monitor the performance of a task by an imaged subject during a functional magnetic resonance imaging (fMRI) procedure.

It is an advantage of embodiments of the present invention that the performance of an fMRI task can be monitored in substantially real-time, e.g. to alert an operator to intervene when poor task compliance is detected.

It is an advantage of embodiments of the present invention that an imaged subject can be informed of poor task performance such as to refocus his/her attention on the task to be performed during an fMRI examination.

It is an advantage of embodiments of the present invention that an fMRI timeseries can be annotated with information regarding subject task performance/compliance, e.g. during (or immediately after) acquisition of the timeseries, such that this annotation information can be taken into account in the analysis of the fMRI timeseries data. For example, a time interval or block of the timeseries can be marked to indicate a low task performance in this interval or block, e.g. such that it can be ignored accordingly (or handled in another suitable manner, e.g. given a lower weight) in a subsequent processing and analysis of the timeseries.

It is an advantage of embodiments of the present invention that an operator can be alerted when an imaged subject performs a task poorly and/or that a measure of task performance and/or compliance can be associated with the fMRI data, e.g. to weight data in accordance with the detected level of performance and/or compliance and/or to take said level into account in statistical analysis of the fMRI data.

It is an advantage of embodiments of the present invention that a blocked-trial design with alternating periods of at least two different conditions, amongst which at least one task condition (e.g. and at least one control condition), may provide a good sensitivity, e.g. a detectable signal in an image voxel or region of multiple voxels (or a detectable signal change when comparing between at least two of those periods) from which a real-time or at least fast a (e.g. near real-time or substantially real-time) determination of task performance during the fMRI imaging run. By using a prolonged 'block', e.g. a substantial period of time, over which the condition of interest is sustained, e.g. by repeating a plurality of trials in each block, a good signal quality (contrast; signal to noise) is achieved that can enable (substantially) real-time detection of performance/compliance, or lack thereof, e.g. a quantification of the (near) present (current; instant) performance and/or compliance of the performed task. The plurality of trials of a same 'block' may be identical events, or at least similar to each other in the sense of each corresponding to the same 'condition' attributed to the block. Furthermore, a blocked-trial design may advantageously reduce the dependence of results determined from the fMRI data, e.g. by statistical analysis, on timing-specific parameters that may be unknown a priori or that may be only approximately known, such as the hemodynamic response function and/or the activation flow coupling response.

It is an advantage of embodiments of the present invention that (an) adverse state(s) of the imaged subject can be detected while an fMRI examination is still in progress (or very recently terminated), such that such adverse state can be corrected and/or the fMRI imaging run can be repeated and/or extended to improve the quality of the data that would be otherwise, without repetition or extension in time, reduced by that adverse state. Examples of such adverse states include a distracted state of mind, a sleepy or sleeping subject, a loss of consciousness, a reduced level of consciousness or awareness, an agitated state, a confused state, and/or other such mental states that are not or less suitable for performing the intended task.

It is an advantage of embodiments of the present invention that poor compliance with a prescribed fMRI task, e.g. due to a lack of (complete) comprehension of the associated task instructions, can be detected and alleviated, e.g. by indicating a further need of assistance by an operator.

It is an advantage of embodiments of the present invention that changes in sustained attention and compliance with task demands during an fMRI scan can be detected, identified and/or quantified.

It is an advantage of embodiments of the present invention that methods and/or devices in accordance with embodiments are particularly suitable to monitor (and/or improve) the efficacy of an fMRI examination of a psychiatric or neurologic patient, e.g. a subject suffering from a psychiatric disorder or neurological disorder or trauma. For example, such disorders and/or traumas may entail a reduced ability to comprehend a range of tasks, to remember task instructions, to maintain a sufficient attention span and/or to execute prescribed mental and/or physical actions. Nonetheless, such complications can also arise when studying a healthy subject (even though, likely, at a lesser frequency of occurrence and/or severity), such that embodiments are not necessarily limited to being suitable for psychiatric and/or neurologic patients.

It is an advantage of embodiments of the present invention that compliance with (and/or performance of) task requirements can be monitored, even for tasks without a directly observable outcome, such as cognitive tasks (e.g. silent word generation, mental imagery, autobiographical memory, ...). For example, for such tasks, it may be difficult to verify, during the scan session, if the imaged subject has performed (or is performing) the prescribed task well, or even has performed the task at all. This difficulty can be overcome or alleviated by a method and/or device in accordance with embodiments of the present invention.

A device and method in accordance with embodiments of the present invention achieves the above objective.

In a first aspect, the present invention relates to a method for monitoring the performance of a predetermined test task executed by a subject during a functional magnetic resonance imaging examination. The method comprises acquiring a timeseries of functional magnetic resonance images of the brain of the subject using a magnetic resonance imaging system. The method comprises providing at least one sensory stimulus via a sensory stimulus source to the subject during the acquisition of the timeseries to prompt the subject to perform the predetermined test task and/or to induce an intended brain activity in accordance with the predetermined test task. The method comprises determining, after providing the sensory stimulus, at least one activity measure indicative of brain activity in at least one predetermined region of interest in the subject's brain imaged by the timeseries of images, and generating at least one signal when the at least one determined activity measure is indicative of a poor performance of and/or compliance to the predetermined test task, in which the signal is generated during the acquisition of the time series and/or before removing the subject from the magnetic resonance imaging system.

In a method in accordance with embodiments of the present invention, the at least one signal may comprise an alert signal to inform an operator.

In a method in accordance with embodiments of the present invention, the at least one signal may comprise an instruction to the magnetic resonance imaging system to extend the acquisition of the timeseries

According to the invention, the at least one signal comprises an instruction to the magnetic resonance imaging system to pause, terminate and/or restart the acquisition of the time series.

In a method in accordance with embodiments of the present invention, the at least one signal may comprise a performance feedback signal provided to the subject.

In a method in accordance with embodiments of the present invention, the at least one signal may comprise annotation information for storing along with the acquired timeseries of functional magnetic resonance images, such that an evolution of the determined activity measure over the timespan of the timeseries can be taken into account when analyzing the timeseries after completion of the acquisition.

In a method in accordance with embodiments of the present invention, the at least one signal may comprise a measure of overall attention or distraction and/or compliance over the complete timeseries, for use in planning future functional magnetic resonance imaging examinations having the same test task design and/or targeted at a same subject population.

In a method in accordance with embodiments of the present invention, a plurality of sensory stimuli may be provided to the subject at different times during the acquisition of the timeseries, the activity measure may be determined repeatedly at and relating to different times during the acquisition, and the signal may be generated if, and, if so, at (i.e. near; shortly after) the time that, the most recently determined activity measure is indicative of a poor performance of and/or compliance.

In a method in accordance with embodiments of the present invention, acquiring the timeseries and providing the sensory stimulus may be performed in accordance with a blocked functional magnetic resonance imaging task paradigm, which comprises time blocks of at least one active state and at least one control state, in which at least one of the plurality of sensory stimuli is comprised in each time block corresponding to the active state.

In a method in accordance with embodiments of the present invention, determining the activity measure may comprise comparing at least one first image of the timeseries acquired while an effect of the stimulus in the brain is presumed to be absent and at least one second image of the timeseries acquired while a direct or indirect effect of the stimulus in the brain is presumed to be present.

In a method in accordance with embodiments of the present invention, the providing the sensory stimulus may comprise displaying a visual cue, emitting an auditory cue, providing a touch sensation and/or providing another type of perceptual stimulus, wherein the activity measure may be determined for at least one region of interest including a sensory brain area, the primary visual cortex, the primary auditory cortex, the primary somatosensory cortex, and/or parts thereof and/or combinations thereof, for which region(s) neural activation is implicated by the sensory stimulus.

In a method in accordance with embodiments of the present invention, providing the sensory stimulus may be adapted to directly or indirectly evoke a brain response in a content-specific higher-order sensory brain region, and the activity measure may be determined for at least one region of interest including said content-specific higher-order sensory brain region or part thereof.

In a method in accordance with embodiments of the present invention, the predetermined test task mat be adapted to evoke visual and/or auditory mental imagery, and the activity measure may be determined for at least one region of interest including a higher-order perceptual and/or memory region and/or a content-specific higher-order sensory region, and/or one or more primary perceptual brain regions, and/or parts thereof and/or combinations thereof.

In a method in accordance with embodiments of the present invention, the predetermined test task may be adapted to evoke motor imagery tasks and the at least one region of interest may comprise motor cortex and/or cerebellar regions; parts thereof and/or combinations thereof.

In a method in accordance with embodiments of the present invention, the predetermined test task may comprise a spatial navigation imagery task, and the at least one region of interest may comprise the hippocampus or part thereof.

In a method in accordance with embodiments of the present invention, the predetermined test task may comprise a mental scene construction task, and the at least one region of interest may comprise the default-mode network and/or hippocampus and/or ventromedial prefrontal cortex; and/or parts thereof and/or combinations thereof.

In a method in accordance with embodiments of the present invention, the predetermined test task may comprise an emotional scene construction task, and the at least one region of interest may comprise the amygdalae or part thereof.

A method in accordance with embodiments of the present invention may comprise providing instructions and/or a trial or pilot run of the predetermined test task or a related task before acquiring the timeseries, to train the subject in execution of the predetermined test task, to test comprehension and/or performance of the predetermined test task and/or to calibrate an expected magnitude of the activity measure and/or to localize the region or regions of interest used in determining the activity measure.

A method in accordance with embodiments of the present invention may comprise acquiring additional information via different imaging modalities and/or physiological parameter sensors, during the acquisition of the timeseries, wherein this additional information is taken into account in determining the activity measure.

In a method in accordance with embodiments of the present invention, determining the activity measure may comprise performing an attentional network activation analysis (e.g. detecting the activation or deactivation of a dorsal and/or ventral attentional network and/or a resting-state network and/or a default-mode network), and/or detecting activation and/or deactivation in at least one region of interest that is implicated in the predetermined task, and/or detecting activation and/or deactivation in at least one region of interest that has no known association with the predetermined task.

In a method in accordance with embodiments of the present invention, the at least one region of interest that has no known association with the predetermined task may comprise the anterior cingulate cortex (ACC), the basal ganglia, the ventro-medial prefrontal cortex (vmPFC) and/or another brain region in which brain activity is indicative of cognitive fatigue.

In a method in accordance with embodiments of the present invention, the at least one region of interest that has no known association with the predetermined task comprises a disorder-specific and/or pathology-specific brain region, in which neural activation is indicative of a hallucination or other episode of the disorder or pathology.

In a method in accordance with embodiments of the present invention, detecting activation and/or deactivation in at least one region of interest that has no known association with the predetermined task is not necessarily limited to being determined after providing the stimulus, e.g. such non-task related activation or deactivation may be checked for continuously (i.e. repeatedly) during the functional magnetic resonance imaging acquisition without necessarily being correlated with the time(s) of presenting the stimulus(/i).

A method in accordance with embodiments of the present invention may comprise a further step of detecting a further activity measure indicative of a sleep state and/or of sleep drowsiness during the timeseries acquisition.
A method in accordance with embodiments of the present invention may comprise detecting motion of the subject during the acquisition of the timeseries, and generating the signal or a further signal if the detected motion exceeds a predetermined threshold.

A method in accordance with embodiments of the present invention may comprise performing a functional magnetic resonance imaging analysis on the acquired timeseries of magnetic resonance imaging images, e.g. distinct from the step of determining the at least one activity measure, e.g. performed after the acquisition of the timeseries has been completed and/or after the subject has been removed from the magnetic resonance imaging system. This fMRI analysis may be a voxel-based analysis, e.g. not constrained to one or more specific regions of interest, for example by fitting a general linear model to each voxel of the imaged volume that is relevant (e.g. contains grey matter) and independently from each other (e.g. even though image smoothing may be used to control voxel correlations).

In a second aspect, the present invention relates to a computer program product comprising machine executable instructions for execution by a processor of an fMRI system wherein execution of the machine executable instructions causes the processor to perform a method in accordance with embodiments of the first aspect of the present invention.

In a third aspect, the present invention relates to an fMRI system with a computer system for monitoring the performance of a predetermined test task executed by a subject during a functional magnetic resonance imaging examination. The computer system comprises an input for receiving, in substantially real-time, a timeseries of functional magnetic resonance images of the brain of the subject acquired using a magnetic resonance imaging system, a first output for providing at least one sensory stimulus via a sensory stimulus source to the subject during the acquisition of said timeseries to prompt the subject to perform the predetermined test task and/or to induce an intended brain activity in accordance with the predetermined test task, a processor for determining, after providing the sensory stimulus, at least one activity measure indicative of brain activity in at least one predetermined region of interest in the subject's brain imaged by the timeseries of images on the basis of images received by said input and for generating at least one signal when said at least one determined activity measure is indicative of a poor performance of and/or compliance to the predetermined test task, and a second output for outputting said at least one signal. The processor is adapted for generating said signal during said acquisition of the timeseries (i.e. before completion of the timeseries) and/or before removing the subject from the magnetic resonance imaging system and wherein the at least one signal comprises an instruction to the magnetic resonance imaging system to pause, terminate and/or restart said acquisition.

The independent and dependent claims describe specific and preferred features of the invention. Features of the dependent claims can be combined with features of the independent claims and with features of other dependent claims as deemed appropriate, and not necessarily only as explicitly stated in the claims.

### BRIEF DESCRIPTION OF THE DRAWINGS

Fig. 1 shows a magnetic imaging system in accordance with embodiments of the present invention.
Fig. 2 shows an illustrative method in accordance with embodiments of the present invention.
Fig. 3 shows a further illustrative example of a method in accordance with embodiments of the present invention.

The drawings are schematic and not limiting. Elements in the drawings are not necessarily represented on scale. The present invention is not necessarily limited to the specific embodiments of the present invention as shown in the drawings.

### DETAILED DESCRIPTION OF EMBODIMENTS

Notwithstanding the exemplary embodiments described hereinbelow, is the present invention only limited by the attached claims. The attached claims are hereby explicitly incorporated in this detailed description, in which each claim, and each combination of claims as allowed for by the dependency structure defined by the claims, forms a separate embodiment of the present invention.

The word "comprise," as used in the claims, is not limited to the features, elements or steps as described thereafter, and does not exclude additional features, elements or steps. This therefore specifies the presence of the mentioned features without excluding a further presence or addition of one or more features.

In this detailed description, various specific details are presented. Embodiments of the present invention can be carried out without these specific details. Furthermore, well-known features, elements and/or steps are not necessarily described in detail for the sake of clarity and conciseness of the present disclosure.

Where reference is made to "real-time" or "near real-time" in the present disclosure, it will be understood by the person skilled in the art that processing operations necessarily require at least some time for computation, such that the real-time or instantaneous processing is obviously constrained by technical capabilities. However, the use of "real-time" indicates that the processing being performed is time-critical in nature, and preferably performed swiftly to allow actions to be taken in response to the determined result, while this result is still relevant. Particularly, in embodiments of the present invention, an activity measure is determined during the acquisition of a timeseries of fMRI images, such that actions can be taken in response to the determined activity measure while that timeseries has not yet been completely collected. Therefore, preferably (even though not strictly necessarily), the processing takes less time than the length (or e.g. than twice the length) in time of a block in the fMRI paradigm/protocol being used (unless, of course, the considered protocol is not a blocked event protocol). For example, this allows a corrective action to be taken before a next block (e.g. a next block of the same event type) in the fMRI protocol design is scheduled to start. Therefore, (near) real-time may refer to a processing time of (only as an example) less than two minutes, or less than one minute, preferably less than 30 seconds, or, even more preferred, less than 10 seconds. Clearly, if a processing time of even substantially less than that, e.g. less than one second, can be achieved without excessive impact on costs (e.g. costs of the required computing hardware, operating power etc.), this may be even more preferred. However, at least some of the embodiments of the present invention may involve alerting an operator of a result based on the (near) real-time computations, who can then take an action in response. This may imply that, considering the time required for the operator to take a responsive action when necessary, the added value of reducing the processing time to less than (for example) a few seconds could be somewhat limited (e.g. unless an automated response is provided as alternative or in addition to alerting the operator).

References to a 'task' in the present disclosure can be interpreted quite broadly. Such task typically involves a specific response in the subject's brain, e.g. a response that may be localizable in time (at the moment when the task is performed or at a moment having a specific temporal relationship to the moment of performing the task) and space (e.g. a specific brain region or regions). However, the task does not necessarily involve an active action of the subject, e.g. may be limited to a passive observation of a stimulus or stimuli (e.g. triggered via any sensory organ or combination of multiple senses) by the subject and/or a subconscious and/or involuntary response to such stimuli, e.g. an emotional response, a mood shift, a sentiment, a memory function or the like. Obviously, this does not exclude tasks that, in fact, do include active (re)actions of the subject as prescribed by a specific task paradigm. Such active task-induced (prescribed) behavior may be externally observable, e.g. a finger movement, speech or vocalization, amongst many other possibilities, but may also be merely an internal process, e.g. a voluntary and conscious process (as opposed to the aforementioned subconscious and/or involuntary responses), such as a thought process, a mental computation, an intentional memory process, an imagined or simulated physical action or scenario, amongst many other possibilities. It is to be noted that tasks that do not involve an externally observable reaction of the subject can be particularly difficult to monitor, i.e. it may be difficult to determine whether the task is actually performed as intended. This challenge can advantageously be overcome by embodiments of the present invention.

In a first aspect, the present invention relates to a method for monitoring the performance of (and/or compliance with) a predetermined test task executed by an imaged subject during a functional magnetic resonance imaging examination. Particularly, the method in accordance with embodiments of the present invention may be a computer-implemented method, e.g. performed by a computer program product when executed on a suitable computing platform of an fMRI system**.**

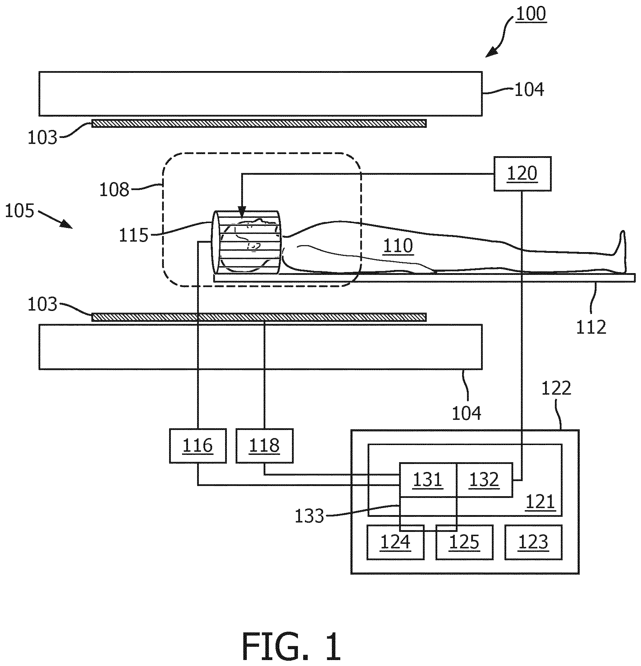

The method is performed by interacting with a magnetic resonance imaging system. Fig. 1 shows an example of such magnetic resonance imaging system 100, e.g. an MRI system that is generally suited to implement step of a method in accordance with embodiments of the present invention. The MRI system 100 comprises a magnet 104, e.g. a superconducting cylindrical magnet through which a bore 105 is defined. Variations of and/or alternatives for this type of magnet are also possible, e.g. the magnet may be a split cylindrical magnet or an open magnet (e.g. in which magnet sections are arranged around, e.g. above and below, an open space for receiving the subject to be imaged). The magnet 104 may comprise a plurality of superconducting coils, e.g. in a cryostat. Inside the bore 105, an imaging region 108 is defined in which a subject can be imaged. In this imaging region 108, the magnetic field of the magnet 104 is typically strong and uniform, i.e. sufficiently strong and uniform to perform MR imaging. For an open magnet or other alternative magnet assembly, there might not be a bore cavity defined, but the imaging region 108 will still be clearly identifiable, e.g. as characterized by a suitable magnetic field strength and homogeneity. The magnetic resonance data acquired by the system, in use thereof, is typically representative of the content of the space defined by the imaging region 108, or a part thereof, e.g. a specific region of interest defined inside this imaging region.

A subject 110, e.g. a human subject such as a patient to be diagnosed or examined, can be, in use, placed inside the imaging region 108. For this, the system may comprise a subject support 112, e.g. an actuated patient couch. By controlling the subject support, a body part or region of interest in the subject on the support can be moved to a suitable position inside the imaging region 108.

The system may further comprise a plurality of magnetic field gradient coils 103, adapted to spatially encode magnetic spins within the imaging region 108 (e.g. by superimposing local magnetic field variations onto the strong magnetic field of the magnet). For example, the magnetic field gradient coils may comprise at least three coils (or sets of coils) to allow spatial encoding in three orthogonal spatial directions, i.e. in any direction in space. The magnetic field gradient coils 103 may be controlled as a function of time, in addition to controlled such as to select the spatial encoding direction, e.g. to create gradients that are pulsed, ramped or otherwise varying as function of time. For example, a power supply (or power supplies) of the magnetic field gradient coils may be controlled by a controller, processor or computer to achieve a magnetic field (gradient) in accordance with a desired spatial and/or temporal function. The system may typically comprise a controller 118 to control the magnetic field gradient coils 103.

The system may typically comprise a radiofrequency (RF) coil 115 (an RF antenna device) which may act as a radiofrequency receiver and transmitter. For example, the RF coil may transmit a signal that disrupts the alignment of (nuclear) spins with the magnetic field (of atoms and molecules in the imaging region 108), and the RF coil may receive a return signal that is generated by a precession and relaxation of the disrupted nuclear spins back to the magnetic field alignment. The RF coil may be a construct comprising a plurality of separate coil elements, and/or support equipment. The RF coil may be integrated in the bore system, or may be a separate component to be placed close to or in contact with the imaged subject. For example, the RF coil(s) may be integrated in a head coil assembly for imaging the brain of the subject 110.

The RF coil 115 comprises, or is connected to, an RF transceiver 116. Obviously, the system may also comprise separate RF transmission and receival antennas and corresponding (separate) receiver and transmitter systems, or any combination of a plurality of antenna coils and transceiver and/or receiver and/or transmitter systems. For example, a plurality of antenna coils may be connected to separate receive and/or transmit channels, which may be controlled separately, in unison or in any combination that is considered suitable for the intended purpose. A number of parallel channels may, for example, be useful for parallel imaging techniques, such as SENSE or ASSET (sensitivity encoding; array coil spatial sensitivity encoding).

The MRI system 100 also comprises a sensory stimulus source 120 to provide a sensory stimulus to the subject during an MRI imaging operation. Such sensory stimuli may include a signal that can be provided to the subject via any of (or combination of) the physical senses of the body, such as touch, smell, taste, hearing and sight. Commonly, the sensory stimulus source may include a light or display to present a visual stimulus to the subject while positioned in the imaging region (including possibly a projection screen and/or optical system to relay displayed information to within the bore volume), and/or a speaker or sound source to present an auditory stimulus to the subject (including possibly a relay system, e.g. using guided air pressure transmission or contact conduction of sound into the bore volume, e.g. to a headphone).

The sensory stimulus source 120 is used, in performing a method in accordance with embodiments, to trigger activity in a brain region of interest in the subject. Thus, the subject receives instructions to perform a 'task' as cued by the sensory stimulus source. As already mentioned, this task may be passive or active (or a combination thereof) in nature. The timing may be controlled with respect to the timing of the collected MRI data, such that acquired images can be analyzed by taking the stimuli presented at the time of image collection into account (or prior to the time of image collection by an at least approximatively known time delay).

The RF transceiver 116, the gradient coil controller 118 and the sensory stimulus source 120 may be connected to a hardware interface 121 of a computer system 122. The hardware interface may, for example, be a digital network interface or data bus interface. The hardware interface may be adapted for exchanging data and/or commands between the computer system and other components of the system. The hardware interface may also be adapted for exchanging data and/or commands between different components of the computer system. The hardware interface is not necessarily a homogenous interface infrastructure, e.g. may comprise or consist of different types of data exchange media, computer networks, communication buses, shared memory access structures and the like.

The MRI system 100 is adapted for acquiring fMRI images. In other words, a timeseries of images can be acquired, in which each image in the sequence is reconstructed, e.g. by the computer system 122, based on signals detected by the RF transceiver and the antenna coil(s) connected thereto. For fMRI imaging, the RF coil(s) may be, specifically, integrated in a head coil assembly to achieve a good signal quality for imaging a subject's brain.

Embodiments in which the computer system comprises a plurality of computers, interconnected by a suitable network infrastructure are not necessarily excluded. For example, processing performed by the computer system may be distributed over a computing cluster or cloud computing platform. Also, while reference is made to a conventional computer architecture hereinbelow, it will be clear to the skilled person that this is not necessarily the case in all embodiments. For example, the computer system may comprise, or even consist of, dedicated hardware for implementing the processing functions described hereinbelow, e.g. comprising an application specific integrated circuit and/or field-programmable gate array hardware. It will also be understood that, where reference is made to a single computer system, different functions of this computer system may be assigned to dedicated computer systems, e.g. which are able to exchange data.

The computer system 122 may comprise at least one processor 123. The processor may be operably connected to the hardware interface, such as to allow the gradient coils, the sensory stimulus source and the RF transceiver to be controlled by the processor and/or to enable processing of data received by the RF transceiver by the processor.

The computer system 122 may comprise a user interface 124, e.g. for interacting with an operator operating the MRI system. The processor may likewise be connected to the user interface, e.g. such that a user can select actions to perform by the MRI system, parameters to apply, review data indicative of the operation of the system and/or images as acquired by the system (or images derived therefrom). The user interface may comprise a display, a keyboard, a pointer device, a touch interface, and/or other such components as are ubiquitous in human-computer interaction systems. The user interface may be adapted to render images, e.g. via the display.

The computer system 122 may comprise a memory 125. The memory may comprise or consist of different types of memory, all of which are (directly or indirectly) accessible to the processor. This may for example include a random access memory, a cache memory, non-volatile memory (such as flash memory), hard drives, solid state drives, and/or other storage devices. The memory may comprise a non-transitory computer-readable medium.

The memory may contain machine-executable instructions to enable the processor to perform various data processing tasks and/or to control other components of the MRI system. The machine-executable instructions may enable the processor to perform at least part of a method in accordance with embodiments of the present invention.

A method in accordance with embodiments of the present invention may be embodied in a source program, an executable program (e.g. a bytecode or intermediate language code, an object code and/or a machine code), a computer-interpretable script and/or any other entity comprising a set of instructions that can be directly or indirectly (e.g. by means of facilitating programs or codes, such as interpreters, just-in-time compilers, compilers, etc., and/or supporting code libraries, frameworks, an operating system, etc.) executed by a computer system of an fMRI device, e.g. by the processor of the computer system 122. It is pointed out that embodiments are not limited to computer code implementations, e.g. the method may be performed (completely or in part) by dedicated hardware specifically designed for the intended method, e.g. in an ASIC, and/or by a hardware configuration that can be loaded in a programmable hardware construct, e.g. an FPGA.

The memory 125 may also contain a representation of pulse sequence commands, which enable the processor to control the MRI system in a corresponding manner, e.g. by controlling the gradient coils and RF transceiver in accordance with these commands. The memory may also contain magnetic resonance imaging data acquired by controlling the MRI system with the pulse sequence commands.

The memory 125 may comprise a representation of sensory stimulus commands (or data) to control the sensory stimulus source 120. These sensory stimulus commands may be associated with, or integrated in, the pulse sequence commands, such that, upon execution, a well-defined relationship in timing between the operations performed by the gradient coils and RF transceiver (and/or further components of the MRI system) and the cues presented to the subject via the sensory stimulus source is established. For example, the sensory stimulus commands may instruct or induce a change between an active state, in which a specific task is performed, and a resting state, e.g. in which no task or another task for reference/control is performed, between acquisitions of the MRI data. Metadata may be associated with the acquired MRI data to indicate a state of the sensory stimulus source, e.g. the information or an indication of the type of information that was presented to the subject, at the time corresponding to the time of acquisition of the MRI data.

The computer system 122 may also be adapted to reconstruct a tomographic image from MRI data acquired from the RF transceiver. Methods for controlling the MRI system using a suitable pulse sequence and for reconstructing tomographic images from the signals collected by the RF transceiver in response are well-known in the art, and will not be discussed in detail in the present disclosure. However, it is noted that the pulse sequence will typically comprise commands or data to control the MRI system such as to collect image data (as reconstructed by corresponding processing of the acquired signals) that is sensitive to changes in the human brain due to brain activity. These changes may rely on a hemodynamic response of the brain in response to brain activity, e.g. an increased blood flow and/or changes in the rate of consumption and/or supply of resources in the blood in active regions of the brain, and/or on a blood-oxygenation level dependent signal contrast.

The computer system 122 may comprise, e.g. may implement via suitable software and/or hardware, a detection and/or analysis module to analyze fMRI images in substantially (near) real-time and to monitor the current attention level of the imaged subject, as explained in detail in the description of a method in accordance with embodiments of the present invention hereinbelow.

The computer system 122 may comprise, e.g. may implement, a response and/or alert module to provide information, based on an output of the detection and/or analysis module, to an operator of the system and/or the subject, in order to correct a loss of attention of the subject during an fMRI examination, e.g. by intervention of the operator and/or by drawing the attention of the subject to this loss of attention to the fMRI task being performed. This will also be further explained hereinbelow in relation to a method in accordance with embodiments.

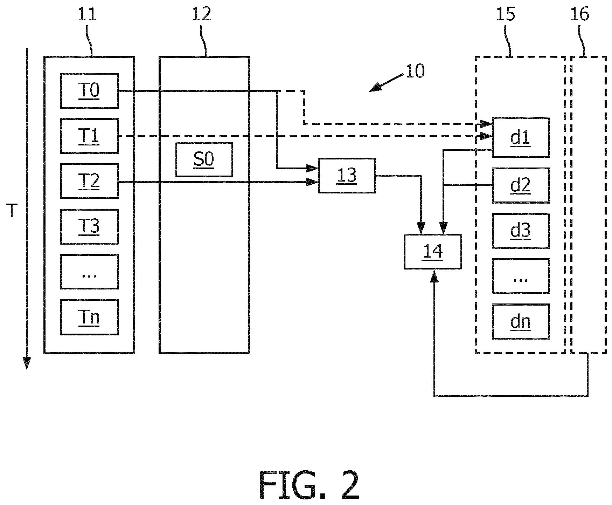

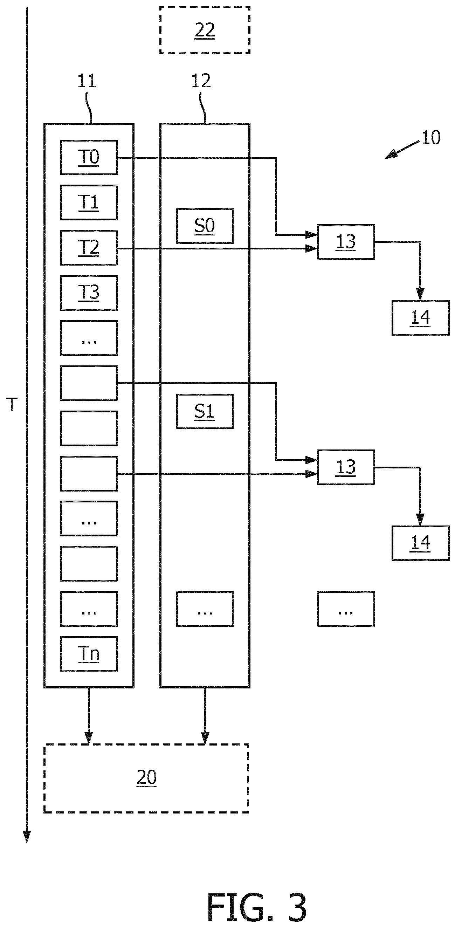

Referring to Fig. 2 (and/or Fig. 3), a method 10, for monitoring the performance of a predetermined test task executed by an imaged subject during a functional magnetic resonance imaging examination, in accordance with embodiments of the present invention is shown. It is to be noted that a vertical axis T is depicted in Fig. 2 and 3 to illustrate the temporal relation of different steps of the method with respect to each other, e.g. a flow of time T. This temporal relationship is only illustrative, but is provided to aid the skilled person in understanding the generic flow of events in a possible method in accordance with embodiments, particularly where this may involve parallel streams of events.

The method 10 comprises acquiring 11 a timeseries of functional magnetic resonance images of the brain of the subject using a magnetic resonance imaging system, e.g. an MRI system 100 as described hereinabove. Acquiring the timeseries of images may comprise controlling the MRI system in accordance with a pulse sequence, and collecting signals by the RF transceiver. The timeseries thus comprises a sequence of images acquired during subsequent time blocks T0, T1, ..., TN (or substantially acquired at a sequence of instants in time T0,T1, ..., TN).

Acquiring the timeseries may also comprise processing the collected signals to reconstruct an image, e.g. a tomographic image. The reconstructed image may be a volumetric (3D) tomographic image, one or more planar (cross-sectional; 2D) images, or a combination thereof. It is known in the art to reconstruct the signals in substantially real-time, i.e. while still acquiring the timeseries (before completion of the series), even though the immediate reconstruction may be performed (yet not necessarily) at a lower resolution, over a smaller region (e.g. only one or a few slices) and/or at a lower quality than a final reconstruction. Such final reconstruction may, for example, be performed at a later time when the timeseries has been collected in its entirety; e.g. such that a diagnosis can be based on information contained in the entire timeseries at its highest achievable reconstruction quality and resolution.

While, depending on the fMRI imaging technique used, the acquired signals may be representative of substantially a same instant in time for different locations in the brain (e.g. using suitable 3D imaging sequences and/or accelerated imaging techniques), or may be representative of slightly different instants in time for different locations in the brain (e.g. using a conventional echo planar imaging technique), it is also known in the art to correct for small time offsets if needed (e.g. using a slice timing correction method) to obtain images that are representative of substantially a single instant in time over the entire imaged volume. Therefore, it can be assumed that the acquired timeseries may comprise images (2D, preferably 3D) that are substantially (or at least approximatively) indicative of the imaged brain at a corresponding sequence of points in time, e.g. by including a suitable pre-processing step on the signals/images if needed or desirable.

Given the state of the art in the field of MRI and fMRI, the present disclosure will not go into detail regarding suitable pulse sequences, image reconstruction methods and/or fMRI analysis techniques (e.g. to create images representative of the brain activity, e.g. statistical maps of assumed brain activity, for example using the BOLD effect as proxy for brain activity, from MRI images having a suitable sensitivity to such brain activity, e.g. T2*-weighted images). The skilled person is well-aware of suitable methods known in the art. However, it is noted that both techniques are known to perform MRI image reconstruction in (near) real-time, as well as to detect brain activity in (near) real-time on the basis of such images (e.g. via estimation of the BOLD response).

As an example, the acquired fMRI data in the timeseries may comprise a plurality of MRI images at a plurality of different echo times following an application of an excitation RF pulse, for each time sample point in the timeseries.

For example, reference is made to EP3660530A1 for a suitable (near) real-time fMRI processing method, without necessarily limiting embodiments of the present invention to that specific approach. In view of the requirements of a method in accordance with embodiments of the present invention, a more simple and/or straightforward approach to determining 13 an activity measure can be considered as well, as will be discussed in detail further hereinbelow, e.g. such as to advantageously reduce the memory and/or processing requirements to determine the activity measure sufficiently fast, e.g. in near real-time. Obviously, this does not preclude a more complex approach, if the computing resources are available. For example, a more conventional fMRI analysis approach, e.g. a commonly applied Statistical Parametric Mapping method, may be applied to the partial timeseries up to the point in time at which the activity measure is being determined (i.e. when the calculations are performed), and this method may be repeated at a later point in time for the timeseries up to that later point in time, if another value for the activity measure is desired at that point in time. It will also be evident that, even if such conventional processing is applied, some intermediate results from a previous calculation (for a shorter partial timeseries and at an earlier point in time) can be readily reused (for a longer partial timeseries and at a later point in time) to simplify the calculations at least to some extent. Examples of such reusable intermediate results may include slice time corrections, motion compensation re-alignment, coregistration to a reference image, normalization, image smoothing, image segmentation, etc. for images of the timeseries that were already collected for the earlier partial sequence. Even the estimation of a general linear model (without limitation thereto) may be simplified if the results or intermediate results of an earlier estimation for a partial timeseries are available. Nonetheless, it is to be noted that, for reasons of efficiency and conservative use of computing resources, methods that are specifically designed to achieve a fast or near real-time fMRI brain activity measure may be preferable to a conventional processing flow, e.g. a conventional flow as exemplified by the algorithms provided in the Statistical Parametric Mapping toolbox (as well-known in the art; see e.g. revision 7771 of SPM12 as publicly available from The Wellcome Centre for Human Neuroimaging, London, UK).

The method 10 comprises providing a sensory stimulus 12, e.g. via the sensory stimulus source 120, to the subject during the acquisition of the timeseries of fMRI images, to prompt the subject to perform the predetermined test task (or element or step thereof) or to directly induce an intended brain activity in the subject's brain by the stimulus in accordance with the predetermined test task (referring to the remark hereinabove, a passive or subconscious brain response to a stimulus can also be considered as a 'task' in accordance with at least some embodiments of the present invention). 'During the acquisition" may refer to at least one image of the timeseries being acquired while an effect of the stimulus in the brain (directly or due to an intended response of the subject in accordance with the task) is presumed and/or intended, e.g. shortly after providing the stimulus, and at least one other image of the timeseries being acquired while the effect of the stimulus can be assumed to be absent, e.g. preceding the stimulus or a sufficient time after the stimulus (e.g. particularly where the subject is not instructed to maintain the prompted activity over a period of time that extends to this 'sufficient' time afterwards). Thus, as is generally known in the art, the effect of the stimulus (direct or indirect) can be evaluated by comparing these at least two images. It is to be noted that, typically, a large number of images may be processed to determine the activity of interest in the brain accurately, e.g. comprising at least ten images in the absence of the effect and at least ten images in the presence of the effect. It is also to be noted that the sensory stimulus is typically repeated, such as to repeatedly induce the brain activity of interest, to increase sensitivity by joint analysis. Furthermore, the stimulus may be repeated during a first block of time, while it may be absent during a second (next) block of time, in which these types of block may alternate for a next number of times to increase robustness even further.

As is known in the art, a task may be selected (e.g. by an operator) from a plurality of different paradigms, which are designed to cause activity in a specific brain region or regions of interest, e.g. for diagnostic purposes or treatment/surgery planning. The different task paradigms may also take into account different subject populations/groups, e.g. may be tailored to patients with a specific disorder or condition. During the fMRI session, the subject (e.g. patient) is then instructed to perform this specific task, in which the stimulus/stimuli are meant to convey these instructions, to directly cause a specific brain activity pattern and/or to act as cues to synchronize the timing of task-related activity by the subject to the timing of the fMRI image acquisition. For a more complex task, the subject may receive detailed instructions beforehand, such that simple cues (the stimuli) can suffice during execution of the task.

Providing the stimulus may comprise displaying a visual cue, e.g. an instruction or instructive pictogram, an image intended to invoke a specific brain response (e.g. a thought, a memory or emotion), or even a cue as simple as a change in lighting (e.g. flash). Providing the stimulus may comprise emitting an auditory cue, e.g. a sound, a tone, a auditory verbal instruction, and/or a verbal or non-verbal sound intended to evoke a specific brain response. Providing the stimulus may also comprise a touch, or another cue that can be sensed by the subject's brain in any other conceivable manner, e.g. release of a molecule that can be detected by the olfactory sense.

The method may take individual differences into account in the ability to perform fMRI tasks between subjects, e.g. particularly taking an underlying disease and/or pathology into account. For example, this antecedent information may be taken into account into selecting a suitable fMRI paradigm/protocol. Furthermore, the method may comprise providing 22 (e.g. automated or by relying on an operator) instructions to the subject prior to acquiring the fMRI timeseries and/or a trial run of the task or a related task. These instructions may vary, even for a same task, depending on the subject (e.g. underlying disease/pathology). Furthermore, the method may comprise providing a stimulus (stimuli) to the subject prior to the fMRI timeseries acquisition to practice the task and/or to test whether comprehension of the task instructions is adequate. For example, a non-imaging, cognition-based experimental procedure may be performed that depends on the psychiatric disorder. In such trial run, sensory stimulation can be applied without already performing the brain scans. Furthermore, the task performed during this trial run may differ (e.g. slightly) from the task executed during the imaging run, e.g. such as to receive feedback from the subject (e.g. verbal or by gestures) to test whether the task is performed correctly (whereas the actual task to be performed during the imaging run does not necessarily requires such feedback). Another difference may be that the trial task could present specific stimuli, whereas the actual imaging task could require the subject to merely imagine (or remember) the same or similar objects, settings and/or scenes. Furthermore, while such difference between actual perception and memory or imagination may advantageously allow the response of the subject to be tested/verified, it may also serve purposes of calibration. For example, during the trial run (or part thereof) a separate fMRI image timeseries (from the one mentioned earlier) may be acquired to detect specific brain areas to use as regions of interest in the real-time task compliance monitored further discussed hereinbelow and/or to calibrate a magnitude of activation/deactivation (e.g. in specific regions of interest) to be expected in this monitoring.

The method 10 comprises, after providing the stimulus but before completion of the acquisition of the timeseries, determining 13 an activity measure indicative of brain activity in a predetermined region of interest in the volume of the subject's brain imaged by the timeseries of fMRI images by comparing at least one first image of the timeseries acquired while an effect of the stimulus in the brain is presumed to be absent and at least one second image of the timeseries acquired while an effect of the stimulus in the brain is presumed. For example, the first image may be acquired before the stimulus was applied, and the second image may be acquired during or after, e.g. shortly after, providing the stimulus, e.g. less than one minute after, e.g. preferably less than 30 seconds after, e.g. less than 10 seconds after. It is to be noted that, while the direct effect of a stimulus in the brain may be typically transient, an indirect effect can be maintained, and therefore detectable, over substantially longer periods in time (e.g. extending over multiple minutes afterwards, e.g. without any limitation on sustaining neural activity over even much longer periods, even though practicality concerns may arise when a block of task-induced activity extends over a time period that is too long), e.g. in combination with instructions to the subject to start a specific mental or (limited) physical activity when presented with the stimulus. While physical activities are obviously limited by the constraints of the scanner bore and a typical requirement (or strong preference) to avoid movement during acquisition of the timeseries, it is to be noted that some limited physical activity may still be possible without disrupting the examination, e.g. finger tapping.

Therefore, while the patient is performing the task, as directed or synchronized by the stimulus/stimuli, and the MRI system collects a timeseries of MRI images, the method in accordance with embodiments provides a (near) real-time analysis of (at least some of) the MRI images to check if the subject is performing the task properly and/or is distracted.

Comparing at least the first and second image may be interpreted broadly, e.g. may involve any operation that involves image information from the first image and the second image to determine a qualitative or quantitative measure that indicates brain activity present in the second image where it was not, or to a lesser extent, present in the first image, or even vice versa, e.g. a decreased brain activity in the second image relative to the first image. This may involve the calculation of an image subtraction, an image division or similar measure of contrast. This may also involve suitable pre-processing and/or processing steps, e.g. to compensate for motion between the images, to correct timing, to register the images to a known coordinate framework, e.g. such that the region of interest can be easily found in the images, image smoothing, and such. This may also involve the estimation of a model, such as a general linear model, to assign a strength and/or confidence to the brain activity in the region of interest, e.g. particularly when taking more than two images into account.

Determining 13 the activity measure may optionally be augmented by additional imaging and/or sensor information, e.g. by acquiring positron emission tomography (PET) images, an electroencephalogram (EEG), ultrasound (US) images and/or other measurements and/or images simultaneously with acquiring the fMRI timeseries. Different sources of information (e.g. different image modalities) may allow different parameters (or a same parameter using a different method) to be tested that could indicate a loss of attention and/or task compliance, such that a more robust signal can be generated to indicate such poor task performance.

However, determining 13 the activity measure may differ from known approaches of conventional fMRI processing (even though not necessarily). Firstly, while in a conventional fMRI imaging approach a relatively large number of images are collected to determine a robust measure of brain activity for each image voxel of the brain, the activity measure determined 13 in accordance with embodiments may be limited to a single scalar value or a few scalar values indicative of activity in one single voxel, in one specific brain region (the region of interest), or in a few brain regions (e.g. the region of interest may consist of a plurality of possibly disjunct regions of interest). In other words, where a conventional fMRI analysis aims at visualizing and/or quantifying the brain regions involved in or (de-)activated by a task, which are only approximately known a-priori (hence the need for imaging), the activity measure in accordance with embodiments is calculated in an a-priori known (i.e. predetermined) brain region that may not be, necessarily, the region that the fMRI examination aims at detecting, but may only be (without limitation thereto though) tangentially involved in performing the task, and preferably in performing the task attentively and diligently. However, these regions of primary interest in the examination and the region used in estimating the activity measure are not necessarily completely disjunct or separate either; for example, the aim of the examination may be to precisely define a brain area involved in a task, whereas a broader region where this brain area is likely situated can be used as the region of interest for determining the activity measure. For example, the region of interest may correspond to a brain gyrus, some adjacent gyri or even an entire brain lobe, in which a specific point or location that is involved in the task is to be localized.

Secondly, the number of images on the basis of which the activity measure is determined may be relatively small, e.g. as few as two. Where a larger number of images in the sequence is preferable to perform an accurate fMRI analysis, the activity measure 13 is preferably determined from only a few (i.e. fewer than comprised in the entire timeseries) images to be more sensitive to an (approximatively) instantaneous change in task compliance or performance. The fact that the estimation of the activity measure can be limited to a specific predetermined region(s) of interest and can be based on only a few images, contribute to an efficient processing, and thus to the desirable near real-time estimation of the activity measure.

However, this does not mean that more images cannot be taken into account. For example, the images on the basis of which the activity measure is determined may comprise all (or many; or most) of the images in the timeseries that have been collected up to the point of calculating the activity measure, and, for example, a regressor may be used in a model fitted to the timeseries to determine a change in activity indicative of a reduced (or increased) compliance or performance, e.g. a decrease (or increase) in attention. Multiple such regressors may be included to model a more complex attentional effect, e.g. other than linear. Furthermore, if the activity measure is repeatedly estimated 13, previous values of the activity measure may be taken into account in estimating such model at a later point in time, e.g. as a covariate to detect a change with respect to a previously estimated measure of activity.

As a third potential difference with respect to a conventional fMRI analysis, it is noted that the detection of a sufficiently strong brain activity (or sufficiently strong decrease thereof) in a region of interest, which is at least tangentially involved in performing the task, does not necessarily require a statistical analysis as commonly used in fMRI analysis. It is to be noted that one of the challenges of a conventional fMRI analysis arises from the requirement of adequately controlling the number of false positives in view of the large number of voxels that are considered (e.g. corresponding to all of the gray matter in the brain). Particularly, a suitable correction of the statistical threshold may be needed, such as a Bonferoni correction (even though more complex alternatives may be commonly used). This is however not the case, or at least less problematic, when a single region of interest, or a relatively small number of regions of interest are considered, e.g. in the case of the (near) real-time analysis in accordance with embodiments.

While it may be important to determine which brain regions are involved in an fMRI task in a robust and statistically reliable manner, the requirements for merely detecting whether a specific brain region (or regions) are activated (or deactivated) by a task, for the purposes of monitoring the task performance, may be considered as less critical. For example, a false positive may merely draw the attention of an operator to a subject that is erroneously considered to be distracted, without much further consequence, whereas a false positive in the results of a final analysis of the fMRI timeseries could potentially lead to (for example) an erroneous medical diagnosis. Therefore, the step of determining 13 the activity measure may be kept fairly simple and therefore efficient to perform in (near) real-time. For example, the region(s) of interest may be defined such as to avoid a large contrast with nearby structures, such that a step of image registration prior to the analysis can be avoided (without limitation thereto). Likewise, processing steps such as image smoothing, e.g. as conventionally applied to allow statistically robust inference (for example, based on Gaussian Random Field properties), and/or slice timing correction may not be (strictly) necessary for the purpose of real-time monitoring.

For example, during the fMRI examination session (e.g. while still acquiring the timeseries), fMRI signals may be processed to generate a transverse relaxation (T2*) map, e.g. the aforementioned second image, for at least the region (or regions) of interest in the brain of the subject when the stimulus is assumed to have a direct or indirect effect on the map (second image) in the region of interest (at least if task compliance is sufficient). For example, a predefined model of fMRI data variations may be taken into account to generate the T2* map on the basis of the acquired RF signals. The transverse relaxation map may be compared to a reference T2* map, e.g. the aforementioned first image, which is generated from fMRI data where the direct or indirect effect is presumed absent (e.g. the first image may be based on data that were collected at a point in time that precedes the stimulus). Thus, a blood-oxygen-level dependent (BOLD) response of the region (or regions) of interest during a current active time window (e.g. shortly after providing the stimulus) may be determined using the results of this comparison. Therefore, the activity measure can be based on (or can correspond to) this estimated BOLD response.

While the second image(s) is preferably an image representative of a current state during the examination, e.g. acquired recently with respect to the action of determining 13 the activity measure, the first image(s) is not necessarily limited to a reference image or images collected in a most recent non-active period (e.g. "resting state block"). Since such reference image may be considered as containing a general background activity of brain, it may be advantageous to combine a plurality of such images, e.g. by averaging (without limitation thereto). For example, many or even all images that have been collected up to the point in time where the activity measure is determined and which are suitable to be used as representative of the control ("resting", "reference") condition may be taken into account, e.g. even if not all of these reference images belong to a most recent "resting state block". Thus, a T2* map may be generated for each reference time window (e.g. a "resting state block"), and the generated reference T2* maps that have been generated up to a point in time of calculating the activity measure may be combined to obtain a relatively robust reference image ("first image").

It will also be clear to the skilled person that data collected for a time block that corresponds to the reference or control condition may be filtered to avoid transient effects of the active condition time blocks, e.g. by excluding some of the data collected during an initial time period of the time block.

For example, in a simple paradigm comprising a sequence of alternating active (A) and resting (R) state blocks, R₁A₁R₂A₂R₃A₃R₄A₄R₃A₅, when calculating the activity measure representative for task compliance during execution of the active state block A₄, the first image(s) may be based on data collected in the resting state blocks R₁, R₂, R₃ and R₄, while the second image(s) may be limited to data collected during the active block A₄. However, it is noted that using data collected in the previous active state blocks is not necessarily excluded either, e.g. a weighting approach may be applied to assign a higher importance to more recently collected data while not discarding earlier data entirely, such that the measure of activity can more accurately follow a change in attention during the examination (e.g. is less sensitive to noise). It is also noted that embodiments are also not necessarily limited to blocked fMRI protocols, e.g. a method in accordance with embodiments may also apply, *mutatis mutandis,* to an event-related protocol.

By determining the activity measure to indicate the neuronal activity in one or more regions of interest in the subject's brain in (near) real-time, a method in accordance with embodiments allows the monitoring of an fMRI examination, particularly during the acquisition of the fMRI timeseries, and allows an operator (or an automated monitoring system adapted to take suitable action) to check whether a task is being performed adequately and/or is not distracted. This is particularly useful in the potentially disordered brain of a neurologic or psychiatric patient, and in case of an fMRI task of which the performance is not readily obvious by external responses of the patient (e.g. a mental task as opposed to finger tapping or other easily detectable task).

Determining 13 the activity measure indicative of brain activity in predetermined regions of interest may also comprise performing a (near) real-time attentional network (e.g. resting-state or default-mode network) activation analysis, e.g. in which estimated activity (e.g. BOLD values) of different regions of interest are considered in relation to each other. Thus, the measure of brain activity (or a component thereof) may also indicate a relation between the activity in different regions, instead of a mere indication of activity in a single corresponding region (or a list of activities in different regions).

For example, to focus attention, remember instructions and handle a predetermined fMRI task, certain resting-state networks may be involved, e.g. the default-mode network may be active during rest and may deactivate accordingly during performance of the task. Other relevant networks for task-related cognition may include the frontoparietal network, and/or the dorsal and/or ventral attention networks (resp. FPN, DAN, VAN). The network activation analysis may comprise the calculation of one or more measures of connectivity and/or coherence that express the joint (coherent) activity of different predetermined regions in the brain. For example, functional connectivity measures may be determined (without limitation thereto) on the basis of a graph analysis, in which nodes of the graph represent different brain regions and the edges of the graph represent the connections between these regions). Simpler (exemplary) approaches may be based on measures of correlation or association between timeseries representative of different brain regions, e.g. may be based on a covariance matrix calculated for a matrix X = (X₁,X₂,... ,Xₙ)^{T}, where each random variable Xᵢ represents a timeseries of detected activity in a corresponding brain region, e.g. by averaging the acquired fMRI singlas over the voxels associated with the brain region.

For example, during an fMRI task-scan session, the activity measure may be determined (e.g. possibly repeatedly) to check in substantially real-time if there is activation and/or deactivation in brain areas that are task-related, e.g. region(s) of interest that are expected to be either activated or deactivated from the hypothesis or hypotheses underlying the task design, and/or based on prior knowledge, e.g. from a reference database of expected activations and deactivations in different brain regions for different task paradigms. If the expected activation and/or deactivation is not detected, i.e. not reflected by the determined activity measure, a warning to an operator may be triggered or other action may be taken as explained further hereinbelow.

Furthermore, the regions of interest for which the activity measure is determined are not necessarily limited to task-related brain areas. For example, the method may alternatively or additionally check for activation of non-relevant and/or non-task related areas, e.g. which can be indicative of a wandering mind. In other words, in addition to checking whether an expected activation or deactivation is present in a specific region of interest, the activity measure may also check for an unexpected activation or deactivation in a region of interest without known association to the fMRI task or with a known association to being distracted or contemplative.

Likewise, an attentional neuronal network activation analysis may be performed to check for attentional networks that are expected to be activated more, or to be activated less, from the task's active state's hypothesis or hypotheses, and/or based on prior knowledge, e.g. a database of expected activation and deactivation for specific attentional networks in specific task paradigms.

A combination of a plurality of these examples may be used. For example, the expected activation and/or deactivation in task-related region(s) of interest may be confirmed in a check. If the condition of this check is not met, a warning or other signal may be generated, while, otherwise, a second check may be performed to check for activation of non-relevant and/or non-task related areas whereas none such activation would be expected on the basis of the task hypothesis/hypothesis and/or prior knowledge. If this second check is positive, a warning or other signal may be generated (which may be identical to the aforementioned signal or warning, or may be different to provide additional disambiguating information). If this second check is negative (i.e. no unexpected activation was detected), a third check may look for expected raised or lowered activation of attentional networks based on the task hypothesis/hypothesis and/or prior knowledge. If this third check is positive, e.g. the detected attentional network activation is in line with expectations, no further action may need to be taken, e.g. until the checks are (optionally) repeated at a later point in time during the fMRI examination. This example of a combination of a three-step check is, of course, only illustrative, and the skilled person would be able to consider many similar or equivalent approaches without exerting an inventive effort.

For example, for a task that uses perceptual input (the stimulus/stimuli), the region(s) of interest may include sensory areas (and/or the primary visual, auditory and/or somatosensory cortex; and/or parts thereof and/or combinations thereof) that are presumed to be (sufficiently) activated or at least not deactivated by the stimulus, e.g. assumed to be active when the task is performed, such that the negation of this assumption could indicate poor attention and/or performance. The region(s) of interest may comprise content-specific higher-order sensory brain regions (or parts thereof and/or combinations thereof), such as the fusiform 'face' area or the parahippocampal 'place' (spatial location) area, which may be presumed to be activated by the stimulus.

Similarly, for a task that uses visual and/or auditory mental imagery, the region(s) of interest may include higher-order perceptual and/or memory regions that are presumed to (sufficiently) activated by the task. The region(s) of interest may comprise primary perceptual regions which may be assumed to be decoupled and/or deactivated by the task. The region(s) of interest may comprise content-specific higher order sensory regions, such as the fusiform face area, which may be assumed to be (re)activated by the task.

Furthermore, for such a mental imagery task, the method may comprise performing a pilot fMRI sequence scan to localize the region(s) of interest and/or to calibrate an expected level of activation (or deactivation/decoupling), in which this pilot fMRI run is performed by direct stimulation, e.g. an overt version of the task as opposed to mental imagery.

Likewise, for motor imagery tasks, an activation of the motor and/or cerebellar regions (or parts thereof; or combinations thereof) may be expected. For spatial navigation imagery tasks, activation of the hippocampus (or part thereof) may be expected. For mental scene construction tasks, activation of the default-mode network (DMN) and/or hippocampus and/or ventromedial prefrontal cortex (or parts/combinations thereof) may be expected. For emotional scene construction tasks, the emotional content may implicate an expected activation (or change in activity w.r.t. the resting state) in the amygdala (or part thereof).

The checking for an unexpected activation or deactivation in a region of interest without known association to the fMRI task or with a known association to being distracted or contemplative may also comprise a (near) real-time analysis of activity that is indicative of cognitive fatigue, such as in region(s) of interest comprising the anterior cingulate cortex (ACC), the basal ganglia, the ventro-medial prefrontal cortex and/or parts thereof and/or combinations thereof.

The checking for unexpected activation or deactivation in a region of interest without known association to the fMRI task at hand may also be adapted to a specific disorder or pathology of the subject. For example, for a patient that is prone to suffering from hallucinations, brain areas activated by such hallucinations (if not involved in the task at hand by direct reliance thereon or by implication via the applied stimuli) may be monitored to detect whether the patient is not suffering from such a hallucinatory episode during the examination. The method may thus additionally check for sensory or awareness experiences that are characteristic for the disorder at hand. For example, for a schizophrenia patient, brain areas involved in hearing voices may be monitored during the scan. When such events are detected, they may be handled in a similar fashion as was discussed hereinabove and below by raising a signal, e.g. to alert an operator (but not necessarily an indistinguishable signal from those signals in case of, e.g., a more generally applicable detection of loss of attention). Such disorder-specific region(s) of interest may include, for example for hallucinatory experiences, parts of the primary visual/auditory/somatosensory cortex/cortices (insofar not conflicting with expected brain activity due to the task at hand), and/or related higher-order brain processes, but may also be defined more specifically by a known (and specific) involvement in the patient disorder or condition.

Furthermore, optionally, the method may also comprise detecting 15 motion of the subject during the acquisition of the fMRI timeseries, e.g. detecting motion in (near) real-time. This motion detection may be performed by analysis of the acquired fMRI images (e.g. of the images that have been most recently acquired of the timeseries). Methods to estimate motion on the basis of, for example, image registration of two or more images of the timeseries are well-known in the art. For example, for each image of the timeseries, e.g. collected at a time Tᵢ, a displacement and/or rotation (not excluding other representations of motion) dᵢ may be determined with respect to a preceding image (e.g. at time Tᵢ₋₁). Note that motion estimation may be more robust if a plurality of preceding images are taken into account, e.g. to estimate an evolution over time of the motion (even though this is not strictly required).

Alternatives are, however, not excluded, such as (to name only a few examples) motion detection on the basis of camera observation and/or by using trackers, e.g. adhesive skin tags that can be tracked in a coordinate space of known spatial relationship to the MRI scanner coordinate frame. When an excessive motion is detected, e.g. where a magnitude of the motion vector (displacement vector) or any of the components of the motion vector (or more generally, a determined parameter of motion, e.g. any element of an affine transformation matrix) exceeds a predetermined threshold (different types of parameters may be compared to different threshold values to take a different effect of scale into account), a signal may be generated, e.g. to alert an operator. Even though this is shown as an arrow to the step of generating 14 the signal, discussed hereinbelow, it is to be noted that a different signal may be generated when motion is detected than when a drop of attention of the subject is detected. Nonetheless, in a particularly simple embodiment, a mere warning sound or light could be triggered to draw the attention of an operator, regardless of whether the detected problem is due to excessive motion or a loss of attention of the subject. A more informative warning might, however, be considered preferable.

Furthermore, the step of determining 13 the activity measure indicative of brain activity in a predetermined region of interest may comprise detecting an activity measure indicative of a sleep state. However, it is to be noted that this can be applied even more broadly, e.g. a sleep state may be detected throughout the imaging procedure, i.e. not necessarily (only) after applying a stimulus. Particularly, a subject falling asleep will, obviously, result in the images acquired after a stimulus to be no longer representative of the brain function intended to be imaged/visualized, but will also change the brain activity in the images that are assumed to be unaffected by the stimulus, e.g. in "resting state blocks", such that those images, also, are no longer a good source of information for defining the reference or control state against which the brain activity of interest is contrasted.

However, this also means that a sleeping state can be detected in images that are assigned to the active state condition as well as in images that are assigned to the control or reference ("resting") state condition. In other words, the method may also comprise a further (optional) step of detecting 16 a further activity measure indicative of a sleep state, during the acquisition of the timeseries, e.g. on the basis of the most recently acquired image (or a subset of recently acquired images). The result of this sleep detection may be processed to generate a signal, e.g. an alert signal to an operator. For the sake of simplicity, this is shown as a link to the step of generating 14 the signal, but it will be understood that the action taken upon detection of a sleep state may differ (or might not differ) from an action taken upon detecting a distracted mind state (e.g. poor task performance).

Even though it is possible to detect a sleeping state regardless of a stimulus being provided priorly, it will be clear that limiting to detecting the sleeping state only when other components of the activity measure, as discussed hereinabove, is not necessarily excluded (e.g. for the sake of simplicity, e.g. by concentrating the performed real-time processing only at those instants where other measure of activity are also determined/calculated, e.g. such that processing can be concentrated on the same images being evaluated). For example, a signal generated in response to detecting a sleeping state may comprise providing a stimulus to the subject for waking him/her up (without limitation thereto; not necessarily the same type of stimulus as used for the task cues).

For example, in order to detect a sleep state, changes of the MRI signal (e.g. T2* voxel values) in the ventrolateral preoptic nucleus (VLPO) of the hippocampus may be detected, e.g. the region(s) of interest may comprise the VLPO or a subregion thereof. It is also to be noted that detection of a sleeping state may also comprise (additionally or alternatively) the detection of the onset of sleep (e.g. a transient state before actually falling asleep). As another example, the images of the timeseries may be used to determine intermediate physiological parameters that may be indicative of sleep or sleep onset, such as a respiration and/or cardiac rate and/or a plethysmogram. It will also be understood that the scanner may be controlled to alternate (not necessarily 1:1 interleaving though) between acquiring images for the fMRI image timeseries and a dedicated image or signal acquisition for the specific purpose of determining such relevant physiological parameter, e.g. respiration and/or heart rate. It is to be noted that it is known that preceding the (actual) sleep state(s), a short transient period of non-waking brain and physiological activity can be detected, which may be referred to as a state of sleep drowsiness. Thus, this transient state can be advantageously detected in advance of, e.g. up to thirty seconds before, sleep actually begins. Therefore, corrective measures can be taken in time as well, such as generating a signal to draw the attention of an operator to this condition and/or to gently alert the subject (preferably without startling him/her).

For example, the method may comprise monitoring movement via a (near) real-time image registration of the fMRI image timeseries, which may be useful information to an operator (and/or automatically correct and/or discard images that were acquired when the subject was moving too much). This movement pattern may be further analyzed to detect a breathing pattern (e.g. by temporal frequency analysis, e.g. Fourier analysis), whereas, for example, a slowing of the breathing could indicate a sleeping state or the onset thereof.

Detecting 16 the further activity measure indicative of a sleep state (a state indicate of sleep and/or onset thereof), during the acquisition of the timeseries, is not necessarily limited to detecting this further activity measure on the basis of acquired MRI image(s). For example, a sensor may be used to monitor one or more physiological parameters that could be indicative of this sleep state, such as a sensor to acquire (preferably repeatedly during the examination) an electroencephalogram (EEG), an electrocardiogram (ECG), a photoplethysmogram (PPG), a cardioballistogram (CBG), an electromyogram (EMG; e.g. of muscles directly or indirectly involved in breathing motion), and/or to monitor the breathing and/or cardiac activity (e.g. breathing rate; heartrate) using a radar (or lidar) system or an optical and/or infrared vital signs monitoring camera system.

The method may also comprise tracking motion of the eye pupil(s) of the subject, e.g. using an MRI scanner-compatible eye tracking method as known in the art. For example, such eye tracking may be used to ascertain that the subject is paying attention to the presented stimulus/stimuli (insofar visual of course) and/or is not distracted by his/her environment instead. A lack of variability of the eye motion may, similarly, also indicate a loss of attention, e.g. a subject who is at risk of falling asleep. A signal may be generated when the eye tracking indicates a high probability of lack of attention to the task, e.g. to alert an operator, as further discussed hereinbelow in relation to signals generated on the basis of the real-time analysis of the fMRI data.

The method 10 further comprises generating 14 a signal, e.g. an alert signal, when the determined activity measure indicates of a poor task performance and/or compliance by the subject. The signal may be generated before completion of the acquisition of the fMRI time series (e.g. at least insofar the activity measure actually indicates a need for the alert), e.g. such that action can be taken by an operator during the further acquisition of the time series. This signal can be considered as an (conditional) output of the method, but is not necessarily an 'output' of a system or device executing the method, e.g. the signal may be entirely internal to the system, i.e. activating a subroutine to pause, terminate, and/or restart the fMRI examination. It will also be clear that the signal may comprise a plurality of separate signals, which may be of a similar or different nature (e.g. a value stored in a memory, a message displayed on a screen, an auditory cue, a computer network transmission, etc.). Such plurality of different signals may also disambiguate between different reasons why the (conditional) output is triggered, e.g. detected motion, expected task-related brain activation not detected, unexpected brain activation in non-task-related brain regions, high probability of sleep/sleep onset, etc.

The method in accordance with embodiments of the present invention thus provides a (near) real-time analysis of MRI images to check if the subject is performing the task properly and/or is distracted, and alert an operator if needed or takes another corrective action, such as changing the imaging protocol (e.g. extending the timeseries or pausing the examination) and/or providing feedback to the subject, e.g. automatically informing the subject of the detected poor performance. The operator, when alerted, may report or give feedback to the patient, such as by explaining the task again or in more detail. The operator may also switch to an easier task to perform (if alternatives exist), may repeat the examination, may extend the length of the timeseries to compensate for poor response quality and/or may take another suitable action.

The activity measure may, for example, indicate a BOLD response in the region(s) of interest in the brain, and may therefore be indicative of an active state of brain structures in the region of interest, e.g. where the associated voxel value(s), e.g. the average of voxel values in the region of interest (without limitation), show a T2* value higher than (or possibly, alternatively lower than, depending on the region of interest and task considered) the corresponding reference (e.g. resting state) T2* value of the same voxel(s) (or e.g. a corresponding average voxel value).

For example, the alert signal may be provided to an operator via the user interface 124 of the computer system 122. Thus, the operator's attention is drawn to the fact the subject may be distracted, may have fallen asleep or is otherwise not performing the task as intended. The operator can then take action, before the time series has been completely collected, to alleviate this problem. For example, the operator may ask the subject to concentrate on the task at hand, the operator may check the state of mind of the subject, and/or may extend the length of the timeseries to compensate for the poor quality data that was collected due to poor task performance.

Other possible actions may include a termination of the fMRI examination to switch to another examination, e.g. using a simpler task that could be easier to perform for the subject.

The alert signal is not necessarily limited to merely providing an informative prompt to the operator. In a method in accordance with embodiments of the present invention, the alert signal may comprise a cue to the subject to refocus attention to the task at hand, e.g. provided to the subject via the sensory stimulus source 120 of the MRI system 100.

In yet another example, the signal may comprise an instruction to the computer system 122 controlling the MRI system 100 to extend the time series (e.g. to include additional time samples after Tn). According to the invention, the signal comprises an instruction to the computer system 122 controlling the MRI system 100 to terminate or pause the acquisition of the time series, for example to allow an operator to provide a further briefing and/or instructions to the imaged subject before continuing or restarting the examination.

The signal may also comprise annotation information (e.g. metadata) that is stored along with the fMRI data, such that the determined activity measure, e.g. an indicator of attention of the subject as function of time, can be taken into account when processing the fMRI data after completion of the examination. For example, the activity measure, or a value derived therefrom, may be used as a covariate in performing an fMRI analysis of the collected imaging data, e.g. as a covariate in a general linear model applied to the timeseries. Alternatively or additionally, a part or parts of the timeseries where the annotation information indicates a low level of attention, a poor task performance and/or poor task compliance may be rejected (e.g. discarded) when performing the fMRI analysis, e.g. the analysis may be limited to the periods in which the task was performed adequately.

Thus, the method may comprise storing annotation information along with the MRI timeseries, after completion of the timeseries acquisition, to indicate the evolution of attention and/or compliance with the task during the examination (e.g. such that a covariate can be constructed from this annotation information). The method may also comprise calculating and recording a measure of overall attention (or distraction) and/or compliance for the completed timeseries, e.g. a percentage of time that the subject did (or did not) pay sufficient attention. For example, such measure of overall attention may be useful for planning future fMRI examinations of the same type (e.g. task design) and/or for the same subject population (e.g. for patients having a specific disorder). It a low compliance is observed for the task and/or patient population, future examinations may, for example, be extended to collect more data, may be marked for redesigning or replacement and/or an estimate of required time for the examination may be adjusted to aid in scheduling.

Generating 14 the signal may comprise generating a plurality of signals, e.g. a combination of two of more examples given hereinabove. The term 'signal' may be interpreted broadly, and the signal, or components of the signal, may include digital data, e.g. stored in a memory or transmitted via a transient or non-transient data carrier, information presented in a user interface, physical signals delivered via the stimulus system, and/or any other useful form of data representation that can be interpreted by a computer system (the same or a different computer system as the system where the signal is generated) and/or human (e.g. the operator or the subject), as would be evident from the type of information being carried by the signal.

For example as illustrated in Fig. 3, a (same or different) sensory stimulus may be repeatedly provided 12 to the subject during the acquisition of the timeseries of fMRI images, and the activity measure may be determined 13 repeatedly, e.g. each time on the basis of a (e.g. most) recent image that was acquired in the timeseries. In other words, the activity measure may be updated to determine a present (current; substantially actual) task performance and/or compliance, and, hence, the alert signal may be generated 14 at different points in time during the fMRI examination when the task compliance and/or performance is assumed to be poor.

As known in the art, the sensory stimulus (or different stimuli) may be repeated in blocks of time (so-called active blocks) which are interleaved with other blocks in time (so-called rest or resting blocks) where such sensory stimuli are not provided, or in which a different type of stimulus/stimuli is/are provided that is/are intended to evoke a different brain response, e.g. a control or reference condition.

Thus, the fMRI timeseries may be split into interleaved resting state periods and active state periods of the subject, which are facilitated (e.g. synchronized) via the stimuli provided to the subject. It is noted that the "resting state" may correspond to any suitable control or reference condition that is different from the "active state" in that it allows specific brain function of interest to be studied by contrast between the "active state" and "resting state". In other words, the terms "active" and "resting" should not be narrowly construed. It will be clear that the number of different types of block (e.g. two for "active" and "resting") can easily be extended if needed, e.g. such that different (sub)tasks and/or reference conditions can be compared to one another. It is also to be noted that the stimuli events are not necessarily organized in such blocks, even though this may have some advantages. Alternatively, isolated events may be triggered at various points in time, without being grouped together in blocks, e.g. as commonly referred to as an event-related protocol/paradigm.

The method in accordance with embodiments of the present invention may comprise (optionally) performing 20 an fMRI analysis on the acquired timeseries of MRI images using a method as known in the art, after completely acquiring the timeseries. This fMRI analysis may differ substantially from the method or methods used to determine 13 the activity measure in (near) real-time during the fMRI timeseries acquisition. For example, the fMRI analysis may be a voxel-based analysis, e.g. not constrained to one or more specific regions of interest, or may be performed to determine brain activation in (a) different region(s) of interest than evaluated during the aforementioned real-time analysis.

In a second aspect, the present invention relates to a computer program product comprising machine executable instructions for execution by a processor, wherein execution of the machine executable instructions causes the processor to perform a method in accordance with embodiments of the first aspect of the present invention. For example, the processor may be (or may be comprised in) the illustrative computer system 122 of the illustrative MRI system 100 (see e.g. Fig. 1 and the description hereinabove).

In a third aspect, the present invention relates to an fMRI system with a computer system for monitoring the performance of a predetermined test task executed by a subject during a functional magnetic resonance imaging examination, for example a computer system 122 as discussed hereinabove.

The computer system comprises an input 131 for receiving, in substantially real-time, a timeseries of functional magnetic resonance images of the brain of the subject acquired using a magnetic resonance imaging system. For example, the input may be comprised in the hardware interface 121 of the computer system 122.

The computer system comprises a first output 132 for providing at least one sensory stimulus via a sensory stimulus source to the subject during the acquisition of said timeseries to prompt the subject to perform the predetermined test task and/or to induce an intended brain activity in accordance with the predetermined test task.

The computer system comprises a processor 123 for determining, after providing the sensory stimulus, at least one activity measure indicative of brain activity in at least one predetermined region of interest in the subject's brain imaged by the timeseries of images on the basis of images received by said input and for generating at least one signal when said at least one determined activity measure is indicative of a poor performance of and/or compliance to the predetermined test task.

The computer system comprises a second output 133 for outputting the at least one signal. The second output 133 may be comprised in the hardware interface 121, in a user interface 124, in a memory 125, or in a combination thereof.

The processor 123 is furthermore adapted to generate the at least one signal during the acquisition of the timeseries and/or shortly after completion, e.g. within ten minutes, e.g. within five minutes, preferably within one minute, of the timeseries and/or before removing the subject from the magnetic resonance imaging system, and wherein the at least one signal comprises an instruction to the magnetic resonance imaging system to pause, terminate and/or restart the acquisition.

The functional magnetic resonance imaging system in accordance with embodiments may be, particularly, adapted to perform a method in accordance with embodiments of the first aspect of the present invention, such that other features, or details of the features described hereinabove, of the MRI system and/or computer system in accordance with embodiments of the present invention shall be clear in view of the description provided further hereinabove relating to a method in accordance with embodiments of the present invention.

## Claims

1. A method (10) for monitoring the performance of a predetermined test task executed by a subject during a functional magnetic resonance imaging examination, the method comprising:
- acquiring (11) a timeseries of functional magnetic resonance images of the brain of the subject using a magnetic resonance imaging system (100);
- providing (12) at least one sensory stimulus via a sensory stimulus source (120) to the subject during the acquisition of said timeseries to prompt the subject to perform the predetermined test task and/or to induce an intended brain activity in accordance with the predetermined test task;
- determining (13), after providing the sensory stimulus, at least one activity measure indicative of brain activity in at least one predetermined region of interest in the subject's brain imaged by the timeseries of images; and
- generating (14) at least one signal when said at least one determined activity measure is indicative of a poor performance of and/or compliance to the predetermined test task, wherein said signal is generated during said acquisition of the time series and/or before removing the subject from the magnetic resonance imaging system **characterised in that**
the at least one signal comprises an instruction to the magnetic resonance imaging system to pause, terminate and/or restart said acquisition (11) of the time series.

2. The method of claim 1, wherein said at least one signal comprises:
- an alert signal to inform an operator of the magnetic resonance imaging system (100), and/or
- an instruction to the magnetic resonance imaging system to extend said acquisition (11), and/or
- a performance feedback signal provided to the subject.

3. The method of claim 1 or claim 2, said at least one signal comprising:
- annotation information for storing along with the acquired (11) timeseries of functional magnetic resonance images, such that an evolution of the determined (13) at least one activity measure over the timespan of said timeseries can be taken into account when analyzing the timeseries after said acquisition (11); and/or
- a measure of overall attention or distraction and/or compliance over the entire timeseries, for use in planning future functional magnetic resonance imaging examinations having a same or similar test task design and/or targeted at a same subject population.

4. The method of any of the previous claims, wherein a plurality of sensory stimuli is provided (12) to the subject at different times during the acquisition (11) of the timeseries, wherein the activity measure is determined (13) repeatedly at and relating to different times during the acquisition, and wherein the signal is generated (14) when and at the time that the most recently determined activity measure is indicative of a poor performance of and/or compliance.

5. The method of any of the previous claims, wherein determining (13) the activity measure comprises comparing at least one first image of the timeseries acquired while an effect of the stimulus in the brain is presumed to be absent and at least one second image of the timeseries acquired while a direct or indirect effect of the stimulus in the brain is presumed to be present.

6. The method of any of the previous claims, wherein providing (12) the sensory stimulus comprises displaying a visual cue, emitting an auditory cue, providing a touch sensation and/or providing another type of perceptual stimulus, wherein the activity measure is determined (13) for at least one region of interest including a sensory brain area, the primary visual cortex, the auditory cortex, the somatosensory cortex, and/or parts thereof and/or combinations thereof, for which neural activation is implicated by the sensory stimulus.

7. The method of any of the previous claims, comprising providing (22) instructions and/or a trial or pilot run of the predetermined test task or a related task before acquiring (11) the timeseries, to train the subject in executing the predetermined test task, to test comprehension and/or performance of the predetermined test task and/or to calibrate an expected magnitude of the activity measure used in determining (13) the activity measure and/or to localize the region or regions of interest used in determining the activity measure.

8. The method of any of the previous claims, comprising acquiring additional information via different imaging modalities and/or physiological parameter sensors, during the acquisition (11) of the timeseries, wherein this additional information is taken into account in determining (13) the activity measure.

9. The method of any of the previous claims, wherein determining (13) the activity measure comprises performing an attentional network activation analysis, and/or detecting activation and/or deactivation in at least one region of interest that is implicated in the predetermined task; and/or detecting activation and/or deactivation in at least one region of interest that has no known association with the predetermined task.

10. The method of claim 9, wherein said at least one region of interest that has no known association with the predetermined task comprises the anterior cingulate cortex, the basal ganglia, the ventro-medial prefrontal cortex and/or another brain region in which brain activity is indicative of cognitive fatigue,
and/or wherein said at least one region of interest that has no known association with the predetermined task comprises a disorder-specific and/or pathology-specific brain region, in which region neural activation is indicative of a hallucination or other episode of said disorder or pathology.

11. The method of any of the previous claims, wherein said method comprises detecting (16) a further activity measure indicative of a sleep state and/or of sleep drowsiness during the timeseries acquisition (11).

12. The method of any of the previous claims, comprising detecting (15) motion of the subject during the acquisition of the timeseries, and generating (14) the signal or generating a further signal if the detected motion exceeds a predetermined threshold.

13. A computer program product comprising machine executable instructions for execution by a processor of an fMRI system**,** the fMRI system comprising an MRI system (100) and a sensory stimulus source (120), wherein execution of the machine executable instructions causes the processor to perform a method in accordance with any of the previous claims.

14. A system comprising a magnetic resonance imaging , MRI, system (100), a sensory stimulus source (120), and a computer system (122) for monitoring the performance of a predetermined test task executed by a subject during a functional magnetic resonance imaging examination, the computer system comprising:
- an input (131) for receiving, in substantially real-time, a timeseries of functional magnetic resonance images of the brain of the subject acquired using the magnetic resonance imaging system (100);
- a first output (132) for providing at least one sensory stimulus via the sensory stimulus source to the subject during the acquisition of said timeseries to prompt the subject to perform the predetermined test task and/or to induce an intended brain activity in accordance with the predetermined test task;
- a processor (123) for determining, after providing the sensory stimulus, at least one activity measure indicative of brain activity in at least one predetermined region of interest in the subject's brain imaged by the timeseries of images on the basis of images received by said input and for generating at least one signal when said at least one determined activity measure is indicative of a poor performance of and/or compliance to the predetermined test task, and
- a second output (133) for outputting said at least one signal;
wherein said processor is adapted for generating said signal during said acquisition of the timeseries and/or shortly after completion of said timeseries acquisition,
wherein the at least one signal comprises an instruction to the MRI system to pause, terminate and/or restart said acquisition of the time series.

## Patentansprüche

1. Verfahren (10) zum Überwachen der Durchführung einer vorbestimmten Testaufgabe, die von einem Subjekt während einer funktionellen Magnetresonanztomographieuntersuchung ausgeführt wird, wobei das Verfahren Folgendes umfasst:
- Erfassen (11) einer Zeitreihe funktioneller Magnetresonanzbilder des Gehirns des Subjekts unter Verwendung eines Magnetresonanztomographiesystems (100);
- Bereitstellen (12) mindestens eines sensorischen Reizes mittels einer sensorischen Reizquelle (120) an das Subjekt während der Erfassung der Zeitreihe, um das Subjekt aufzufordern, die vorbestimmte Testaufgabe durchzuführen und/oder eine beabsichtigte Gehirnaktivität in Übereinstimmung mit der vorbestimmten Testaufgabe hervorzurufen;
- Bestimmen (13), nach Bereitstellen des sensorischen Reizes, mindestens eines Aktivitätsmaßes, das auf Gehirnaktivität in mindestens einem vorbestimmten Bereich von Interesse in dem Gehirn des Subjekts hinweist, der durch die Zeitreihe von Bildern abgebildet wird; und
- Erzeugen (14) mindestens eines Signals, wenn die mindestens eine bestimmte Aktivitätsmessung auf eine schlechte Durchführung und/oder Einhaltung der vorbestimmten Testaufgabe hinweist, wobei das Signal während der Erfassung der Zeitreihe und/oder vor dem Entfernen des Subjekts aus dem Magnetresonanztomographiesystem erzeugt wird, **dadurch gekennzeichnet, dass**
das mindestens eine Signal eine Anweisung an das Magnetresonanztomographiesystem umfasst, die Erfassung (11) der Zeitreihe zu pausieren, zu beenden und/oder neuzustarten.

2. Verfahren nach Anspruch 1, wobei das mindestens eine Signal Folgendes umfasst:
- ein Warnsignal, um einen Bediener des Magnetresonanztomographiesystems (100) zu informieren, und/oder
- eine Anweisung an das Magnetresonanztomographiesystem, die Erfassung (11) zu verlängern, und/oder
- ein Leistungsrückmeldesignal, das dem Subjekt bereitgestellt wird.

3. Verfahren nach Anspruch 1 oder Anspruch 2, wobei das mindestens eine Signal Folgendes umfasst:
- Anmerkungsinformationen zum Speichern zusammen mit der erfassten (11) Zeitreihe von funktionellen Magnetresonanzbildern, sodass eine Entwicklung des bestimmten (13) mindestens einen Aktivitätsmaßes über die Zeitspanne der Zeitreihe berücksichtigt werden kann, wenn die Zeitreihe nach der Erfassung (11) analysiert wird; und/oder
- ein Maß einer allgemeinen Aufmerksamkeit oder Ablenkung und/oder Einhaltung über die gesamte Zeitreihe, zur Verwendung bei der Planung zukünftiger funktioneller Magnetresonanztomographieuntersuchungen, die ein gleiches oder ähnliches Testaufgabendesign aufweisen und/oder auf dieselbe Subjektpopulation ausgerichtet sind.

4. Verfahren nach einem der vorstehenden Ansprüche, wobei dem Subjekt eine Vielzahl von sensorischen Reizen zu verschiedenen Zeitpunkten während der Erfassung (11) der Zeitreihe bereitgestellt wird (12), wobei das Aktivitätsmaß wiederholt zu und in Bezug auf verschiedene(n) Zeitpunkten während der Erfassung bestimmt wird (13), und wobei das Signal erzeugt wird (14), wenn und zu dem Zeitpunkt, dass das zuletzt bestimmte Aktivitätsmaß auf eine schlechte Durchführung und/oder Einhaltung hinweist.

5. Verfahren nach einem der vorstehenden Ansprüche, wobei Bestimmen (13) des Aktivitätsmaßes Vergleichen mindestens eines ersten Bilds der Zeitreihe, die erfasst wurde, während angenommen wurde, dass eine Wirkung des Reizes im Gehirn nicht vorliegt, und mindestens eines zweiten Bilds der Zeitreihe umfasst, die erfasst wurde, während angenommen wurde, dass eine direkte oder indirekte Wirkung des Reizes in dem Gehirn vorliegt.

6. Verfahren nach einem der vorstehenden Ansprüche, wobei das Bereitstellen (12) des sensorischen Reizes das Anzeigen eines visuellen Hinweises, das Aussenden eines akustischen Hinweises, das Bereitstellen eines Berührungsgefühls und/oder das Bereitstellen eines anderen Typs von Wahrnehmungsreiz umfasst, wobei das Aktivitätsmaß für mindestens einen Bereich von Interesse bestimmt wird (13), beinhaltend einen sensorischen Gehirnbereich, den primären visuellen Cortex, den auditorischen Cortex, den somatosensorischen Cortex und/oder Teile davon und/oder Kombinationen davon, bei denen der sensorische Reiz eine neuronale Aktivierung impliziert.

7. Verfahren nach einem der vorstehenden Ansprüche, das Bereitstellen (22) von Anweisungen und/oder eines Probe- oder Pilotdurchlaufs der vorbestimmten Testaufgabe oder einer verwandten Aufgabe vor Erfassen (11) der Zeitreihe umfasst, um das Subjekt im Ausführen der vorbestimmten Testaufgabe zu trainieren, um ein Verständnis und/oder eine Durchführung der vorbestimmten Testaufgabe zu testen und/oder eine erwartete Größe des Aktivitätsmaßes zu kalibrieren, das beim Bestimmen (13) des Aktivitätsmaßes verwendet wird, und/oder um den Bereich oder die Bereiche von Interesse zu lokalisieren, die beim Bestimmen des Aktivitätsmaßes verwendet werden.

8. Verfahren nach einem der vorstehenden Ansprüche, das Erfassen zusätzlicher Informationen mittels unterschiedlicher Bildgebungsmodalitäten und/oder physiologischer Parametersensoren während der Erfassung (11) der Zeitreihen umfasst, wobei diese zusätzlichen Informationen beim Bestimmen (13) des Aktivitätsmaßes berücksichtigt werden.

9. Verfahren nach einem der vorstehenden Ansprüche, wobei das Bestimmen (13) des Aktivitätsmaßes das Durchführen einer Aufmerksamkeitsnetzwerkaktivierungsanalyse und/oder das Detektieren einer Aktivierung und/oder Deaktivierung in mindestens einem Bereich von Interesse, den die vorbestimmten Aufgabe impliziert, umfasst; und/oder das Detektieren einer Aktivierung und/oder Deaktivierung in mindestens einem Bereich von Interesse, der keine bekannte Verknüpfung mit der vorbestimmten Aufgabe aufweist.

10. Verfahren nach Anspruch 9, wobei der mindestens eine Bereich von Interesse, der keine bekannte Verknüpfung mit der vorbestimmten Aufgabe aufweist, den anterioren cingulären Cortex, die Basalganglien, den ventromedialen präfrontalen Cortex und/oder einen anderen Gehirnbereich umfasst, in dem die Gehirnaktivität auf kognitive Ermüdung hinweist,
und/oder wobei mindestens ein Bereich von Interesse, der keine bekannte Verknüpfung mit der vorbestimmten Aufgabe aufweist, einen störungsspezifischen und/oder pathologiespezifischen Gehirnbereich umfasst, in dem eine neuronale Aktivierung auf eine Halluzination oder eine andere Episode der Störung oder Pathologie hinweist.

11. Verfahren nach einem der vorstehenden Ansprüche, wobei das Verfahren Detektieren (16) eines weiteren Aktivitätsmaßes umfasst, das auf einen Schlafzustand und/oder Schlafmüdigkeit während der Zeitreihenerfassung (11) hinweist.

12. Verfahren nach einem der vorstehenden Ansprüche, das Detektieren (15) von Bewegung des Subjekts während der Erfassung der Zeitreihe und Erzeugen (14) des Signals oder Erzeugen eines weiteren Signals umfasst, wenn die detektierte Bewegung einen vorbestimmten Schwellenwert überschreitet.

13. Computerprogrammprodukt, das maschinenausführbare Anweisungen zur Ausführung durch einen Prozessor eines fMRI-Systems umfasst, wobei das fMRI-System ein MRI-System (100) und eine sensorische Reizquelle (120) umfasst, wobei die Ausführung der maschinenausführbaren Anweisungen den Prozessor veranlasst, ein Verfahren nach einem der vorstehenden Ansprüche durchzuführen.

14. System, das ein Magnetresonanztomographie-, MRI-, System (100), eine sensorische Reizquelle (120) und ein Computersystem (122) zum Überwachen der Durchführung einer vorbestimmten Testaufgabe umfasst, die von einem Subjekt während einer funktionellen Magnetresonanztomographieuntersuchung ausgeführt wird, wobei das Computersystem Folgendes umfasst:
- einen Eingang (131) zum Empfangen, im Wesentlichen in Echtzeit, einer Zeitreihe funktioneller Magnetresonanzbilder des Gehirns des Subjekts unter Verwendung eines Magnetresonanztomographiesystems (100);
- einen ersten Ausgang (132) zum Bereitstellen mindestens eines sensorischen Reizes mittels der sensorischen Reizquelle an das Subjekt während der Erfassung der Zeitreihe, um das Subjekt aufzufordern, die vorbestimmte Testaufgabe durchzuführen und/oder eine beabsichtigte Gehirnaktivität in Übereinstimmung mit der vorbestimmten Testaufgabe hervorzurufen;
- einen Prozessor (123) zum Bestimmen, nach dem Bereitstellen des sensorischen Reizes, mindestens eines Aktivitätsmaßes, das auf Gehirnaktivität in mindestens einem vorbestimmten Bereich von Interesse in dem Gehirn des Subjekts hinweist, der durch die Zeitreihe von Bildern abgebildet wird, auf der Basis von Bildern, die durch den Eingang empfangen werden, und zum Erzeugen mindestens eines Signals, wenn das mindestens eine bestimmte Aktivitätsmaß auf eine schlechte Durchführung und/oder Einhaltung der vorbestimmten Testaufgabe hinweist, und
- einen zweiten Ausgang (133) zum Ausgeben des mindestens einen Signals;
wobei der Prozessor dazu ausgelegt ist, das Signal während der Erfassung der Zeitreihe und/oder kurz nach Abschluss der Zeitreihenerfassung zu erzeugen,
wobei das mindestens eine Signal eine Anweisung an das MRI-System umfasst, die Erfassung der Zeitreihe zu pausieren, zu beenden und/oder neuzustarten.

## Revendications

1. Procédé (10) de surveillance de la performance d'une tâche de test prédéterminée exécutée par un sujet pendant un examen d'imagerie par résonance magnétique fonctionnelle, le procédé comprenant :
- l'acquisition (11) d'une série chronologique d'images par résonance magnétique fonctionnelle du cerveau du sujet à l'aide d'un système d'imagerie par résonance magnétique (100) ;
- la fourniture (12) d'au moins un stimulus sensoriel via une source de stimulus sensoriel (120) au sujet pendant l'acquisition de ladite série chronologique pour inciter le sujet à réaliser la tâche de test prédéterminée et/ou pour induire une activité cérébrale prévue conformément à la tâche de test prédéterminée ;
- la détermination (13), après la fourniture du stimulus sensoriel, d'au moins une mesure d'activité indiquant l'activité cérébrale dans au moins une région d'intérêt prédéterminée dans le cerveau du sujet imagée par la série chronologique d'images ; et
- la génération (14) d'au moins un signal lorsque ladite au moins une mesure d'activité déterminée indique une mauvaise performance de et/ou conformité à la tâche de test prédéterminée, dans lequel ledit signal est généré pendant ladite acquisition de la série chronologique et/ou avant le retrait du sujet du système d'imagerie par résonance magnétique, **caractérisé en ce que**
le au moins un signal comprend une instruction donnée au système d'imagerie par résonance magnétique pour interrompre, terminer et/ou redémarrer ladite acquisition (11) de la série chronologique.

2. Procédé selon la revendication 1, dans lequel ledit au moins un signal comprend :
- un signal d'alerte pour informer un opérateur du système d'imagerie par résonance magnétique (100), et/ou
- une instruction donnée au système d'imagerie par résonance magnétique pour étendre ladite acquisition (11), et/ou
- un signal de retour de performance fourni au sujet.

3. Procédé selon la revendication 1 ou la revendication 2, ledit au moins un signal comprenant :
- des informations d'annotation à stocker conjointement avec la série chronologique acquise (11) d'images par résonance magnétique fonctionnelle, de telle sorte qu'une évolution de la au moins une mesure d'activité déterminée (13) sur la durée de ladite série chronologique puisse être prise en compte lors de l'analyse de la série chronologique après ladite acquisition (11) ; et/ou
- une mesure de l'attention ou de la distraction globale et/ou de la conformité sur l'ensemble de la série chronologique, à utiliser dans la planification de futurs examens d'imagerie par résonance magnétique fonctionnelle présentant une conception de tâche de test identique ou similaire et/ou ciblant une même population de sujets.

4. Procédé selon l'une quelconque des revendications précédentes, dans lequel une pluralité de stimuli sensoriels est fournie (12) au sujet à différents moments pendant l'acquisition (11) de la série chronologique, dans lequel la mesure d'activité est déterminée (13) de manière répétée à et en rapport avec différents moments pendant l'acquisition, et dans lequel le signal est généré (14) lorsque et au moment où la dernière mesure d'activité déterminée indique une mauvaise performance et/ou conformité.

5. Procédé selon l'une quelconque des revendications précédentes, dans lequel la détermination (13) de la mesure d'activité comprend la comparaison d'au moins une première image de la série chronologique acquise en même temps qu'un effet du stimulus dans le cerveau est présumé absent et d'au moins une seconde image de la série chronologique acquise en même temps qu'un effet direct ou indirect du stimulus dans le cerveau est présumé présent.

6. Procédé selon l'une quelconque des revendications précédentes, dans lequel la fourniture (12) du stimulus sensoriel comprend l'affichage d'une indication visuelle, l'émission d'une indication sonore, la fourniture d'une sensation tactile et/ou la fourniture d'un autre type de stimulus perceptuel, dans lequel la mesure d'activité est déterminée (13) pour au moins une région d'intérêt incluant une zone cérébrale sensorielle, le cortex visuel primaire, le cortex auditif primaire, le cortex somatosensoriel primaire et/ou des parties de ceux-ci et/ou des combinaisons de ceux-ci, pour laquelle l'activation neuronale est impliquée par le stimulus sensoriel.

7. Procédé selon l'une quelconque des revendications précédentes, comprenant la fourniture (22) d'instructions et/ou d'un essai ou d'un essai-pilote de la tâche de test prédéterminée ou d'une tâche connexe avant l'acquisition (11) de la série chronologique, pour apprendre au sujet à exécuter la tâche de test prédéterminée, pour tester la compréhension et/ou la performance de la tâche de test prédéterminée et/ou pour étalonner une grandeur attendue de la mesure d'activité utilisée pour déterminer (13) la mesure d'activité et/ou pour localiser la région ou les régions d'intérêt utilisées pour déterminer la mesure d'activité.

8. Procédé selon l'une quelconque des revendications précédentes, comprenant l'acquisition d'informations supplémentaires via différentes modalités d'imagerie et/ou différents capteurs de paramètres physiologiques, pendant l'acquisition (11) de la série chronologique, dans lequel ces informations supplémentaires sont prises en compte dans la détermination (13) de la mesure d'activité.

9. Procédé selon l'une quelconque des revendications précédentes, dans lequel la détermination (13) de la mesure d'activité comprend la réalisation d'une analyse d'activation du réseau attentionnel, et/ou la détection de l'activation et/ou de la désactivation dans au moins une région d'intérêt qui est impliquée dans la tâche prédéterminée ; et/ou la détection de l'activation et/ou de la désactivation dans au moins une région d'intérêt qui ne présente aucune association connue avec la tâche prédéterminée.

10. Procédé selon la revendication 9, dans lequel ladite au moins une région d'intérêt qui ne présente aucune association connue avec la tâche prédéterminée comprend le cortex cingulaire antérieur, les noyaux gris centraux, le cortex préfrontal ventromédian et/ou une autre région cérébrale dans laquelle l'activité cérébrale indique une fatigue cognitive,
et/ou dans lequel ladite au moins une région d'intérêt qui ne présente aucune association connue avec la tâche prédéterminée comprend une région cérébrale spécifique à un trouble et/ou spécifique à une pathologie dans laquelle l'activation neuronale indique une hallucination ou un autre épisode dudit trouble ou de ladite pathologie.

11. Procédé selon l'une quelconque des revendications précédentes, dans lequel ledit procédé comprend la détection (16) d'une autre mesure d'activité indiquant un état de sommeil et/ou de somnolence pendant l'acquisition (11) de série chronologique.

12. Procédé selon l'une quelconque des revendications précédentes, comprenant la détection (15) d'un mouvement du sujet pendant l'acquisition de la série chronologique et la génération (14) du signal ou la génération d'un autre signal si le mouvement détecté dépasse un seuil prédéterminé.

13. Produit de programme informatique comprenant des instructions exécutables par machine destinées à être exécutées par un processeur d'un système IRMf, le système IRMf comprenant un système IRM (100) et une source de stimulus sensoriel (120), dans lequel l'exécution des instructions exécutables par machine amène le processeur à réaliser un procédé conformément à l'une quelconque des revendications précédentes.

14. Système comprenant un système d'imagerie par résonance magnétique, IRM (100), une source de stimulus sensoriel (120) et un système informatique (122) pour surveiller la performance d'une tâche de test prédéterminée exécutée par un sujet pendant un examen d'imagerie par résonance magnétique fonctionnelle, le système informatique comprenant :
- une entrée (131) pour recevoir, sensiblement en temps réel, une série chronologique d'images par résonance magnétique fonctionnelle du cerveau du sujet acquises à l'aide du système d'imagerie par résonance magnétique (100) ;
- une première sortie (132) pour fournir au moins un stimulus sensoriel via la source de stimulus sensoriel au sujet pendant l'acquisition de ladite série chronologique pour inciter le sujet à réaliser la tâche de test prédéterminée et/ou pour induire une activité cérébrale prévue conformément à la tâche de test prédéterminée ;
- un processeur (123) pour déterminer, après la fourniture du stimulus sensoriel, au moins une mesure d'activité indiquant une activité cérébrale dans au moins une région d'intérêt prédéterminée dans le cerveau du sujet imagée par la série chronologique d'images sur la base d'images reçues par ladite entrée et pour générer au moins un signal lorsque ladite au moins une mesure d'activité déterminée indique une mauvaise performance de et/ou conformité à la tâche de test prédéterminée, et
- une seconde sortie (133) pour délivrer en sortie ledit au moins un signal ;
dans lequel ledit processeur est conçu pour générer ledit signal pendant ladite acquisition de la série chronologique et/ou peu de temps après l'achèvement de ladite acquisition de série chronologique,
dans lequel le au moins un signal comprend une instruction donnée au système IRM pour interrompre, terminer et/ou redémarrer ladite acquisition de la série chronologique.
